# EUROPEAN PATENT APPLICATION

(11) **EP 4 845 062 A1**
(43) Date of publication of application: **25.11.2026**
(21) Application number: 25747648.1
(22) Date of filing: 21.01.2025
(51) Int. Cl.: H04L 1/00, H03M 13/03

(54) **COMMUNICATION METHOD AND DEVICE**

(30) Priority: 31.01.2024 CN 202410142563
(71) Applicant: Huawei Technologies Co., Ltd., Shenzhen, Guangdong 518129 (CN)
(72) Inventor: XIANG, Hongyu, Shenzhen, Guangdong 518129 (CN); PANG, Xu, Shenzhen, Guangdong 518129 (CN); CHEN, Lei, Shenzhen, Guangdong 518129 (CN)
(74) Representative: Huawei European IPR
(86) International application number: PCT/CN2025/073690
(87) International publication number: WO 2025/162076

(57) **Abstract**

This application provides a communication method and apparatus. The method includes: A first apparatus performs channel encoding processing on a first data packet based on first context information, to obtain an encoded first data packet, where the first context information is associated with first data having a first error tolerance capability, the first context information indicates time association and/or spatial association between two frames, the first error tolerance capability indicates that a frame to which the first data belongs is supported to be obtained based on a preset quantity of data packets, the first data includes N data packets, the first data packet is any one of the N data packets, and N is a positive integer; and the first apparatus sends the encoded first data packet to a second apparatus. According to the method, encoding efficiency can be effectively improved, and data transmission reliability and data transmission performance (or efficiency) can also be improved.

## Description

### CROSS-REFERENCE TO RELATED APPLICATIONS

This application claims priority to Chinese Patent Application No. 202410142563.8, filed with the China National Intellectual Property Administration on January 31, 2024 and entitled "COMMUNICATION METHOD AND APPARATUS", which is incorporated herein by reference in its entirety.

### TECHNICAL FIELD

This application relates to the field of communication technologies, and in particular, to a communication method and apparatus.

### BACKGROUND

In recent years, with the increasing requirements for communication efficiency in the 5th generation (5th generation, 5G) and the 6th generation (6G), and implementation and application of artificial intelligence technologies in various fields, a semantic communication technology based on deep learning becomes a feasible approach to resolve a bottleneck of conventional information transmission. Compared with a conventional communication technology in which a source is encoded before transmission, the semantic communication technology encodes semantic information extracted from a source before transmission. Existing research shows that the semantic communication technology or manner has higher communication efficiency and an anti-channel interference capability. A semantic communication system is an end-to-end system including modules such as semantic encoding, joint source and channel encoding, joint source and channel decoding, and semantic decoding, and is used for semantic communication of multi-modal information such as images/videos, texts, and voices. Variable-rate transmission of semantic communication can be implemented through joint source and channel encoding, thereby greatly improving performance. However, based on semantic communication, currently, there is no good channel coding scheme proposed to optimize or improve transmission performance.

### SUMMARY

This application provides a communication method and apparatus. In the method, channel encoding of data is implemented based on context information of the data, so that data transmission performance can be effectively improved.

According to a first aspect, an embodiment of this application provides a communication method. The method may be performed by a first apparatus, or may be performed by a chip, a chip system, a logic module, or software corresponding to the first apparatus. This is not limited herein. Using the first apparatus as an example, the method may include: The first apparatus performs channel encoding processing on a first data packet based on first context information, to obtain an encoded first data packet, where the first context information is associated with first data having a first error tolerance capability, the first context information indicates time association and/or spatial association between two frames, the first error tolerance capability indicates that a frame to which the first data belongs is supported to be obtained based on a preset quantity of data packets, the first data includes N data packets, the first data packet is any one of the N data packets, and N is a positive integer; and the first apparatus sends the encoded first data packet to a second apparatus.

Using photo-type data as an example, the context information may indicate time association and/or spatial association between two adjacent frames of photos. For ease of description, the two adjacent frames are referred to as a current frame and a next frame herein. Time information and/or spatial information of a next frame of photo may be deduced or predicted by using time information and/or spatial information of a current frame of photo and the context information (the time association and/or spatial association between the current frame and the next frame). Time information: A target between adjacent frames does not change greatly, and a position does not change abruptly. Spatial information: A specific relationship exists between a target and a background around the target. When an appearance of the target changes greatly, the relationship can help distinguish the target from the background.

For example, the first data is the photo-type data. The first data may be a frame of photo or an area in the frame of photo. The first data may include a plurality of data packets. An error tolerance capability of the first data packet may mean that the frame of photo or the area in the frame of photo is supported to be obtained or generated based on a specific quantity (or a preset quantity) of data packets in the plurality of data packets. In a possible implementation, a smaller quantity of data packets based on which the frame of photo or the area in the frame of photo corresponding to the first data is generated indicates a stronger error tolerance capability of the first data, and a larger quantity of data packets based on which the frame of photo or the area in the frame of photo corresponding to the first data is generated indicates a weaker error tolerance capability of the first data. In this embodiment of this application, the error tolerance capability of the first data may be further understood as an error correction capability or a restoration capability of the data. In a possible implementation, the error correction capability of the first data may mean that an error of a specific quantity of data is supported to be corrected when the frame of photo to which the first data belongs is restored/generated.

In the foregoing, the first data is used as an example to describe the context information and the error tolerance capability, which are not only for the first data, and are applicable to all other data similar to the first data.

In the solution of this application, the first context information is associated with the first data having the first error tolerance capability. The first apparatus performs channel encoding on the first data packet (the first data packet is any one of the N data packets of the first data) based on the first context information, to obtain the encoded first data packet, and then sends the encoded first data packet to the second apparatus. It can be learned that in the method, a transmitting end performs channel encoding processing on each data packet in the data based on the context information associated with the data, and then sends the data packet to a receiving end. In this way, encoding efficiency can be effectively improved, and data transmission reliability and data transmission performance (or efficiency) can also be improved.

In a possible implementation, that the first apparatus performs channel encoding processing on the first data packet of the N data packets based on the first context information, to obtain the encoded first data packet may include the following steps:

Step 1: Respectively perform channel encoding processing on M first data packets based on the first context information by using M encoding methods, to obtain M encoded data packets. The M first data packets may be obtained by copying the first data packet, the M encoding methods are in one-to-one correspondence with the M first data packets (that is, the M encoding methods may be used to encode the M first data packets in one-to-one correspondence, to obtain the corresponding encoded data packets), and M is an integer greater than 1.

In a possible implementation, that the first apparatus respectively performs channel encoding processing on the M first data packets based on the first context information by using the M encoding methods, to obtain the M encoded data packets may include: first obtaining channel state information; and then performing channel encoding processing on the M first data packets based on the first context information and the channel state information CSI by using the M encoding methods, to obtain the M encoded data packets. In this embodiment of this application, the first apparatus may obtain the channel state information CSI after performing measurement with reference to an existing channel measurement procedure, or obtain the channel state information CSI in another manner. This is not limited herein.

In this embodiment of this application, a correspondence between the M encoding methods and the M first data packets may be a one-to-one relationship. In a possible implementation, a correspondence between K encoding methods and the M first data packets is not a one-to-one relationship, where K is equal to M or K is a positive integer not equal to M. For example, the correspondence between the K encoding methods and the M first data packets includes at least one of a one-to-one relationship, a one-to-many relationship, and a many-to-one relationship. How to match the K encoding methods and the M first data packets to implement the solution may be flexibly set based on an actual requirement. This is not specifically limited.

Step 2: Obtain the encoded first data packet based on the M encoded data packets. That is, the first apparatus may perform combination processing on the M encoded data packets, to obtain the encoded first data packet.

In this embodiment of this application, the implementation of combination processing may include but is not limited to that the first apparatus may use the M encoded data packets as an input of a neural network, and an output of the neural network is the encoded first data packet, where a parameter (for example, a weight on a neuron line) of the neural network may be obtained in advance through training. Alternatively, the first apparatus may obtain the encoded first data packet based on the M encoded data packets by using a maximum likelihood method.

In this implementation, the first apparatus may implement effective channel encoding processing on the first data packet based on the first context information. In a special case, M may alternatively be equal to 1. In this implementation, the first apparatus performs effective and concurrent channel encoding processing on the first data packet based on the first context information, so that channel encoding efficiency can be effectively improved.

In a possible implementation, the first apparatus includes a first protocol layer and a second protocol layer. In this case, the first apparatus may respectively perform, at the first protocol layer or the second protocol layer, channel encoding processing on the M first data packets based on the first context information by using the M encoding methods, to obtain the M encoded data packets (that is, the foregoing step 1 may be performed at the first protocol layer of the first apparatus, or may be performed at the second protocol layer of the first apparatus). The first apparatus may obtain, at the second protocol layer, the encoded first data packet based on the M encoded data packets (that is, the foregoing step 2 may be performed at the second protocol layer of the first apparatus).

In this implementation, using the first data packet of the first data as an example, an encoding processing process may be performed at each protocol layer (for example, the first protocol layer or the second protocol layer). A process of obtaining the final encoded first data packet based on a plurality of encoded data packets may be performed at a receiving end (for example, the second protocol layer) that transmits a data packet at a protocol layer at which encoding is performed, to effectively complete a channel encoding process of the first data packet.

In a possible implementation, the M encoding methods are in one-to-one correspondence with M channels between the first protocol layer and the second protocol layer. In another possible implementation, a correspondence between the K encoding methods and the M channels may not be one-to-one, where K is equal to M or K is a positive integer not equal to M. For example, the correspondence between the K encoding methods and the M channels includes one or more of a one-to-one relationship, a many-to-one relationship, and a one-to-many relationship.

In this embodiment of this application, the used encoding method may be an encoding method obtained through evolution based on an encoding method, for example, artificial intelligence AI code, low-density parity-check LDPC code, or polar polar code. This is not limited herein.

In this implementation, the M encoded data packets after encoding can better match a corresponding channel, to ensure transmission reliability and efficiency.

In this embodiment of this application, the first protocol layer and the second protocol layer may be relative, and generally refer to different protocol layers. On a transmitting end side, the first protocol layer transmits sent data/information to the second protocol layer; and on a receiving end side, the second protocol layer transmits received data/information to the first protocol layer. The first protocol layer may be but is not limited to any one of a packet data convergence protocol PDCP layer, a radio link control RLC layer, a media access control MAC layer, and a physical PHY layer. The second protocol layer may be but is not limited to any one of a packet data convergence protocol PDCP layer, a radio link control RLC layer, a media access control MAC layer, and a physical PHY layer. However, in a special case, the first protocol layer and the second protocol layer may alternatively be or belong to a same protocol layer.

For example, if the first protocol layer is the PDCP layer, the second protocol layer may be any one of the radio link control RLC layer, the media access control MAC layer, and the physical PHY layer. If the first protocol layer is the RLC layer, the second protocol layer may be either the media access control MAC layer or the physical PHY layer. If the first protocol layer is the MAC layer, the second protocol layer may be the physical PHY layer.

In a possible implementation, the encoded first data packet carries first indication information, and the first indication information indicates that the encoded first data packet is associated with the first data. In this implementation, the receiving end can distinguish received encoded data packets, to process the received encoded data packets differently.

In a possible implementation, the first indication information further indicates the first error tolerance capability corresponding to the first data packet.

In this implementation, the receiving end can learn of an error tolerance capability of data corresponding to the data packet, so that a decoding status corresponding to the data is subsequently decided and fed back based on the error tolerance capability of the data.

In a possible implementation, the method further includes: The first apparatus obtains the first context information. That the first apparatus obtains the first context information may include but is not limited to that the first apparatus extracts the first data based on a preset model (for example, an artificial intelligence AI model), to obtain the first context information, or directly obtains the first context information from an application layer.

In this implementation, the first apparatus can effectively obtain context information of the first data for subsequent data encoding processing.

In a possible implementation, the method further includes: The first apparatus sends the first context information to the second apparatus, where the first context information is used for decoding the encoded first data packet.

In this implementation, the first apparatus (a transmitting end) can further send first context information of the first data to the second apparatus (a receiving end), so that the second apparatus (the receiving end) can effectively perform subsequent data decoding processing based on the first context information of the first data.

According to a second aspect, an embodiment of this application provides a communication method. The method may be performed by a second apparatus, or may be performed by a chip, a chip system, a logic module, or software corresponding to the second apparatus. This is not limited herein. Using the second apparatus as an example, the method may include: The second apparatus receives an encoded first data packet; and the second apparatus performs channel decoding processing on the encoded first data packet based on first context information, to obtain a first data packet. The first context information is associated with first data having a first error tolerance capability, the first context information indicates time association and/or spatial association between two frames, the first error tolerance capability indicates that a frame to which the first data belongs is supported to be obtained based on a preset quantity of data packets, the first data includes N data packets, the first data packet is any one of the N data packets, and N is a positive integer.

Using photo-type data as an example, the context information may indicate time association and/or spatial association between two adjacent frames of photos. For ease of description, the two adjacent frames are referred to as a current frame and a next frame herein. Time information and/or spatial information of a next frame of photo may be deduced or predicted by using time information and/or spatial information of a current frame of photo and the context information (the time association and/or spatial association between the current frame and the next frame). Time information: A target between adjacent frames does not change greatly, and a position does not change abruptly. Spatial information: For example, a specific relationship exists between a target and a background around the target. When an appearance of the target changes greatly, the relationship can help distinguish the target from the background.

For example, the first data is the photo-type data. The first data may be a frame of photo or an area in the frame of photo. The first data may include a plurality of data packets. An error tolerance capability of the first data packet may mean that the frame of photo or the area in the frame of photo is supported to be obtained or generated based on a specific quantity (or a preset quantity) of data packets in the plurality of data packets. In a possible implementation, a smaller quantity of data packets based on which the frame of photo or the area in the frame of photo corresponding to the first data is generated indicates a stronger error tolerance capability of the first data, and a larger quantity of data packets based on which the frame of photo or the area in the frame of photo corresponding to the first data is generated indicates a weaker error tolerance capability of the first data. In this embodiment of this application, the error tolerance capability of the first data may be further understood as an error correction capability or a restoration capability of the data. In a possible implementation, the error correction capability of the first data may mean that an error of a specific quantity of data is supported to be corrected when the frame of photo to which the first data belongs is restored/generated.

In this embodiment of this application, the second apparatus serves as a receiving end, and after receiving the encoded first data packet, the second apparatus performs channel decoding processing on the encoded first data packet based on the first context information, to obtain the first data packet. In this method, a transmitting end performs channel encoding on the first data packet by using first context information of the first data, and similarly, the receiving end performs channel decoding on the encoded first data packet by using the first context information of the first data, so that decoding correctness (or a decoding capability) and decoding efficiency can be improved.

In a possible implementation, the method further includes: The second apparatus receives the first context information from the first apparatus; or the second apparatus extracts initial first feature data based on a preset model, to obtain context information, and updates the context information based on the current encoded first data packet, to obtain the first context information. In this implementation, the second apparatus (the receiving end) can effectively obtain the first context information of the first data for subsequent decoding processing.

In a possible implementation, that the second apparatus performs channel decoding processing on the encoded first data packet based on the first context information, to obtain the first data packet may include the following steps:

Step 1: Respectively perform channel decoding processing on M encoded first data packets based on the first context information by using M decoding methods, to obtain M decoded data packets. The M encoded first data packets may be obtained by copying the encoded first data packet, the M decoding methods are in one-to-one correspondence with the M encoded first data packets (that is, the M decoding methods may be used to decode the M encoded first data packets in one-to-one correspondence, to obtain the corresponding decoded data packets), and M is an integer greater than 1.

In a possible implementation, that the second apparatus respectively performs channel decoding processing on the M encoded first data packets based on the first context information by using the M decoding methods, to obtain the M decoded data packets may include: first obtaining channel state information; and then performing channel decoding processing on the M encoded first data packets based on the first context information and the channel state information CSI by using the M decoding methods, to obtain the M decoded data packets. In this embodiment of this application, the second apparatus may obtain the channel state information CSI after performing measurement with reference to an existing channel measurement procedure, or obtain the channel state information CSI in another manner. This is not limited herein.

In this embodiment of this application, a correspondence between the foregoing M decoding methods and the M encoded first data packets may be a one-to-one relationship. In a possible implementation, a correspondence between K decoding methods and the M encoded first data packets may not be a one-to-one relationship, where K is equal to M or K is a positive integer not equal to M. For example, the correspondence between the K decoding methods and the M encoded first data packets may include at least one of a one-to-one relationship, a one-to-many relationship, and a many-to-one relationship. How to match the K decoding methods and the M encoded first data packets to implement the solution may be flexibly set based on an actual requirement. This is not specifically limited.

Step 2: Obtain the first data packet based on the M decoded data packets. That is, the second apparatus may perform combination processing on the M decoded data packets, to obtain the first data packet.

In this embodiment of this application, the implementation of combination processing may include but is not limited to that the second apparatus may use the M decoded data packets as an input of a neural network, and an output of the neural network is the first data packet, where a parameter (for example, a weight on a neuron line) of the neural network may be obtained in advance through training. Alternatively, the second apparatus may obtain the first data packet based on the M decoded data packets by using a maximum likelihood method.

In this implementation, the second apparatus (the receiving end) performs concurrent channel decoding processing on the encoded first data packet based on the first context information, so that channel decoding efficiency can be effectively improved.

In a possible implementation, the second apparatus includes a first protocol layer and a second protocol layer. In this case, the second apparatus may respectively perform, at the first protocol layer or the second protocol layer, channel decoding processing on the M encoded first data packets based on the first context information by using the M decoding methods, to obtain the M decoded data packets (that is, the foregoing step 1 may be performed at the first protocol layer of the second apparatus, or may be performed at the second protocol layer of the second apparatus). The second apparatus may obtain, at the first protocol layer, the first data packet based on the M decoded data packets (that is, the foregoing step 2 may be performed at the first protocol layer of the second apparatus).

In this implementation, using the first data packet of the first data as an example, a decoding processing process of the encoded first data packet may be performed at each layer (for example, the first protocol layer or the second protocol layer). A process of obtaining the final first data packet based on a plurality of decoded data packets may be performed at a receive layer (for example, the first protocol layer) that transmits a data packet at a protocol layer at which decoding is performed, to effectively complete a channel decoding process of the encoded first data packet.

In a possible implementation, the M decoding methods may be in one-to-one correspondence with M channels between the first protocol layer and the second protocol layer.

In this embodiment of this application, the first protocol layer and the second protocol layer may be relative, and generally refer to different protocol layers. On a transmitting end side, the first protocol layer transmits sent data/information to the second protocol layer; and on a receiving end side, the second protocol layer transmits received data/information to the first protocol layer. The first protocol layer may be but is not limited to any one of a packet data convergence protocol PDCP layer, a radio link control RLC layer, a media access control MAC layer, and a physical PHY layer. The second protocol layer may be but is not limited to any one of a packet data convergence protocol PDCP layer, a radio link control RLC layer, a media access control MAC layer, and a physical PHY layer. However, in a special case, the first protocol layer and the second protocol layer may alternatively be or belong to a same protocol layer.

In a possible implementation, the encoded first data packet carries first indication information, and the first indication information indicates that the encoded first data packet is associated with the first data. In this implementation, the receiving end can distinguish received encoded data packets, to process the received encoded data packets differently.

In a possible implementation, the first indication information may further indicate the first error tolerance capability corresponding to the first data packet.

In this implementation, the receiving end learns of an error tolerance capability of data corresponding to the data packet, so that a decoding status corresponding to the data may be subsequently decided and fed back based on the error tolerance capability of the data.

In a possible implementation, the method further includes: The second apparatus sends first information or second information to the first apparatus based on a successfully decoded data packet, where the first information indicates that decoding succeeds, and the second information indicates that decoding fails. In this implementation, the first apparatus (the transmitting end) effectively learns of the decoding status of the receiving end.

In a possible implementation, that the second apparatus sends the first information or the second information to the first apparatus based on the successfully decoded data packet includes: sending the first information to the first apparatus when the second apparatus determines, based on the successfully decoded data packet, that a first condition is met, where the first condition may include but is not limited to one or more of the following:
(1) a ratio of a quantity of successfully decoded data packets to a quantity of received encoded data packets is not less than a first threshold;
(2) a quantity of unsuccessfully decoded data packets is within a quantity range indicated by the first error tolerance capability; and
(3) an application layer restores the first data based on the successfully decoded data packet.

In this implementation, the receiving end can feed back, based on a total decoding status, that the decoding succeeds to the transmitting end when a preset condition is met, so that feedback efficiency can be improved while feedback validity is ensured.

In a possible implementation, that the second apparatus sends the first information or the second information to the first apparatus based on the successfully decoded data packet may include: sending the second information to the first apparatus when the second apparatus determines, based on the successfully decoded data packet, that a second condition is met, where the second condition may include but is not limited to one or more of the following:
(1) a ratio of a quantity of successfully decoded data packets to a quantity of received encoded data packets is less than a first threshold;
(2) a quantity of unsuccessfully decoded data packets exceeds a quantity range indicated by the first error tolerance capability; and
(3) an application layer cannot restore the first data based on the successfully decoded data packet.

In this implementation, the receiving end can feed back, based on a total decoding status, that the decoding fails to the transmitting end when a preset condition is met, so that feedback efficiency can be improved while feedback validity is ensured.

In a possible implementation, the second information further indicates to retransmit an encoded data packet that is unsuccessfully decoded.

In this implementation, in a case in which the decoding fails, the receiving end may indicate, to the transmitting end, to retransmit the encoded data packet that is unsuccessfully decoded, to ensure that the receiving end can successfully complete the decoding and restore corresponding data.

According to a third aspect, this application further provides a communication apparatus. The communication apparatus is a first apparatus or a chip in a first apparatus. The communication apparatus has a function of implementing any method provided in the foregoing first aspect. The communication apparatus may be implemented by hardware, or may be implemented by hardware executing corresponding software. The hardware or the software includes one or more units or modules corresponding to the foregoing functions.

In a possible design, the communication apparatus includes a processor. The processor is configured to support the communication apparatus in performing a corresponding function of the first apparatus in the foregoing method. The communication apparatus may further include a storage. The storage may be coupled to the processor, and the storage stores program instructions and data that are necessary for the communication apparatus. Optionally, the communication apparatus further includes an interface circuit. The interface circuit is configured to support communication between the communication apparatus and a device like a service satellite, for example, data or signal receiving and sending. For example, the communication interface may be a transceiver, a circuit, a bus, a module, or another type of communication interface.

In a possible design, the communication apparatus includes corresponding functional modules respectively configured to implement steps in the foregoing method. The function may be implemented by hardware, or may be implemented by hardware executing corresponding software. The hardware or the software includes one or more modules corresponding to the foregoing functions.

In a possible design, a structure of the communication apparatus includes a processing unit and a communication unit. These units may perform corresponding functions in the foregoing method examples. For details, refer to the descriptions in the method according to the first aspect. Details are not described herein again.

According to a fourth aspect, this application further provides a communication apparatus. The communication apparatus is a second apparatus or a chip in a second apparatus. The communication apparatus has a function of implementing any method provided in the foregoing second aspect. The communication apparatus may be implemented by hardware, or may be implemented by hardware executing corresponding software. The hardware or the software includes one or more units or modules corresponding to the foregoing functions.

In a possible design, the communication apparatus includes a processor. The processor is configured to support the communication apparatus in performing a corresponding function of the second apparatus in the foregoing method. The communication apparatus may further include a storage. The storage may be coupled to the processor, and the storage stores program instructions and data that are necessary for the communication apparatus. Optionally, the communication apparatus further includes an interface circuit. The interface circuit is configured to support communication between the communication apparatus and a device like a terminal device and a core network device, for example, data or signal receiving and sending. For example, the communication interface may be a transceiver, a circuit, a bus, a module, or another type of communication interface.

In a possible design, the communication apparatus includes corresponding functional modules respectively configured to implement steps in the foregoing method. The function may be implemented by hardware, or may be implemented by hardware executing corresponding software. The hardware or the software includes one or more modules corresponding to the foregoing functions.

In a possible design, a structure of the communication apparatus includes a processing unit and a communication unit. These units may perform corresponding functions in the foregoing method examples. For details, refer to the descriptions in the method according to the second aspect. Details are not described herein again.

According to a fifth aspect, a communication apparatus is provided. The communication apparatus includes a processor and an interface circuit. The interface circuit is configured to receive a signal from a communication apparatus other than the communication apparatus and transmit the signal to the processor, or send a signal from the processor to a communication apparatus other than the communication apparatus. The processor is configured to implement the method in the foregoing first aspect and any possible implementation by using a logic circuit or by executing code instructions.

According to a sixth aspect, a communication apparatus is provided. The communication apparatus includes a processor and an interface circuit. The interface circuit is configured to receive a signal from a communication apparatus other than the communication apparatus and transmit the signal to the processor, or send a signal from the processor to a communication apparatus other than the communication apparatus. The processor is configured to implement the method in the foregoing second aspect and any possible design by using a logic circuit or by executing code instructions.

According to a seventh aspect, a computer-readable storage medium is provided. The computer-readable storage medium stores a computer program or instructions. When the computer program or the instructions are executed by a processor, the method according to any aspect of the foregoing first aspect and second aspect and any possible implementation is implemented.

According to an eighth aspect, a computer program product storing instructions is provided. When the instructions are run by a processor, the method according to any one of the foregoing first aspect to fourth aspect and the possible implementations is implemented.

According to a ninth aspect, a chip system is provided. The chip system includes a processor, and may further include a storage, configured to implement the method according to any one of the foregoing first aspect and second aspect and the possible implementations. The chip system may include a chip, or may include a chip and another discrete component.

According to a tenth aspect, a communication system is provided. The communication system includes the first apparatus according to the first aspect and the second apparatus according to the second aspect.

For technical effects that can be achieved by the technical solutions according to any one of the foregoing third aspect to tenth aspect, refer to the descriptions of the technical effects that can be achieved by the technical solutions according to the foregoing first aspect and second aspect. Details are not described repeatedly.

### BRIEF DESCRIPTION OF DRAWINGS

FIG. 1 is a diagram of an architecture of a communication system according to an embodiment of this application;
FIG. 2A is an example diagram of a structure of a protocol layer according to an embodiment of this application;
FIG. 2B is an example diagram of a structure of a data packet according to an embodiment of this application;
FIG. 3A is a diagram of downlink data transmission according to an embodiment of this application;
FIG. 3B is an example diagram of a structure of data packet encapsulation according to an embodiment of this application;
FIG. 3C is an example diagram of context information between two photos according to an embodiment of this application;
FIG. 4A is a schematic flowchart of a communication method according to an embodiment of this application;
FIG. 4B is a schematic flowchart of a communication method according to an embodiment of this application;
FIG. 5 is a schematic flowchart of a communication method according to an embodiment of this application;
FIG. 6 is a schematic flowchart of an embodiment according to an embodiment of this application;
FIG. 7 is a diagram of a structure of a data packet according to an embodiment of this application;
FIG. 8A(a), FIG. 8A(b), FIG. 8A(c), and FIG. 8A(d) each are a diagram of a structure of a protocol on an access network device side according to an embodiment of this application;
FIG. 8B(a), FIG. 8B(b), FIG. 8B(c), and FIG. 8B(d) each are a diagram of a structure of a protocol on a terminal device side according to an embodiment of this application;
FIG. 9 is a diagram of decoding result feedback according to an embodiment of this application;
FIG. 10 is a diagram of a structure of a communication apparatus according to an embodiment of this application;
FIG. 11 is a diagram of a structure of another communication apparatus according to an embodiment of this application; and
FIG. 12 is a diagram of an apparatus structure of a chip according to an embodiment of this application.

### DESCRIPTION OF EMBODIMENTS

The following describes the technical solutions in embodiments of this application with reference to the accompanying drawings in embodiments of this application. It is clear that the described embodiments are merely some but not all of embodiments of this application. In this application, the terms "first" and "second" and corresponding term numbers are intended to distinguish between similar objects but do not necessarily describe a specific order or sequence. It should be understood that the terms used in such a way are interchangeable in proper circumstances, which is merely a discrimination manner that is used when objects having a same attribute are described in embodiments of this application. In addition, the terms "include", "contain" and any other variants mean to cover the non-exclusive inclusion, so that a process, method, system, product, or device that includes a series of units is not necessarily limited to those units, but may include other units not expressly listed or inherent to such a process, method, product, or device. The method and the apparatus provided in embodiments of this application are based on a same or similar technical concept. As problem resolving principles of the method and the apparatus are similar, mutual reference may be made to implementations of the apparatus and the method. Repeated descriptions are not provided again.

The technical solutions in embodiments of this application may be applied to various communication systems, for example, a universal mobile telecommunications system (universal mobile telecommunications system, UMTS), a wireless local area network (wireless local area network, WLAN), a wireless fidelity (wireless fidelity, Wi-Fi) system, a 4th generation (4th generation, 4G) mobile communication system like a long term evolution (long term evolution, LTE) system, a 5th generation (5th generation, 5G) mobile communication system like a new radio (new radio, NR) system, and a future evolved communication system like a 6th generation (6th generation, 6G) mobile communication system. In particular, embodiments of this application may be applicable to a semantic communication system.

All aspects, embodiments, or features are presented in this application by describing a system that may include a plurality of devices, components, modules, and the like. It should be appreciated and understood that each system may include another device, component, module, and the like, and/or may not include all devices, components, modules, and the like described with reference to the accompanying drawings. In addition, a combination of these solutions may be used. In addition, in embodiments of this application, terms such as "example" and "for example" are used to give an example, an illustration, or a description. Any embodiment or design scheme described as an "example" in this application should not be explained as being more preferred or having more advantages than another embodiment or design scheme. Exactly, the term "example" is used to present a concept in a specific manner. In embodiments of this application, "of (of)", "corresponding, relevant (corresponding, relevant)", and "corresponding (corresponding)" may be interchangeably used sometimes. It should be noted that meanings expressed by the terms are consistent when differences of the terms are not emphasized.

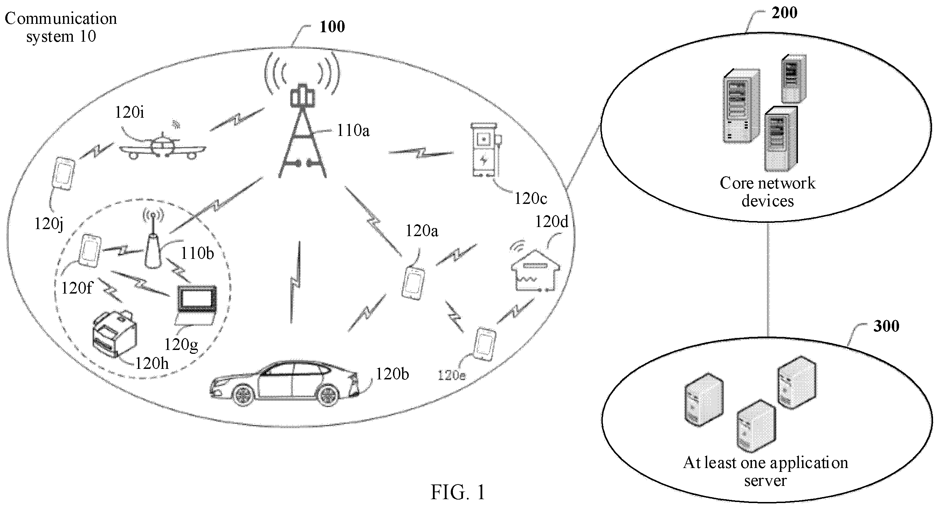

For ease of understanding embodiments of this application, a communication system shown in FIG. 1 is first used as an example to describe in detail a communication system applicable to embodiments of this application. As shown in FIG. 1, the communication system 10 includes a radio access network (radio access network, RAN) 100 and a core network (core network, CN) 200. Optionally, the communication system 10 may further include a data network (data network, DN) 300.

The following respectively describes in detail the RAN 100, the CN 100, and the DN 300 in FIG. 1.

### (1) RAN 100:

The RAN 100 may include at least one radio access network device (which may also be referred to as an access network device, for example, 110a and 110b in FIG. 1), and may further include at least one terminal device (for example, 120a to 120j in FIG. 1). The terminal device may be connected to the radio access network device in a wireless manner. Terminal devices may be connected to each other in a wired or wireless manner, and access network devices may be connected to each other in a wired or wireless manner.

The access network device and the terminal device may be at fixed positions, or may be movable. The access network device and the terminal device may be deployed on land, including an indoor or outdoor scenario, and a handheld or a vehicle-mounted scenario; or may be deployed on water; or may be deployed on an airplane, a balloon, and an artificial satellite in the air. Application scenarios of the access network device and the terminal device are not limited in embodiments of this application. Roles of the access network device and the terminal device may be relative. For example, a helicopter or an uncrewed aerial vehicle 120i in FIG. 1 may be configured as a mobile access network device. For the terminal device 120j that accesses the radio access network 100 via 120i, 120i is an access network device. However, for a first access network device 10a, 120i is a terminal device, that is, 110a and 120i communicate with each other by using a radio air interface protocol. Certainly, 110a and 120i may alternatively communicate with each other by using an interface protocol between access network devices. In this case, for 110a, 120i is also an access network device. Therefore, both the access network device and the terminal device may be collectively referred to as communication apparatuses. 110a and 110b in FIG. 1 may be referred to as communication apparatuses having a function of the access network device, and 120a to 120j in FIG. 1 may be referred to as communication apparatuses having a function of the terminal device.

### (1.1) Terminal device:

The terminal device may also be referred to as user equipment (user equipment, UE), a terminal, a user apparatus, an access terminal, a subscriber unit, a subscriber station, a mobile station (mobile station, MS), a remote station, a remote terminal, a mobile device, a user terminal, a terminal unit, a terminal station, a terminal apparatus, a wireless communication device, a user agent, or a user apparatus.

For example, the terminal device in embodiments of this application may be a mobile phone (mobile phone), a personal digital assistant (personal digital assistant, PDA) computer, a laptop computer (laptop computer), a tablet computer (Pad), an uncrewed aerial vehicle, a computer that has a wireless transceiver function, a machine type communication (machine type communication, MTC) terminal device, a virtual reality (virtual reality, VR) terminal device, an augmented reality (augmented reality, AR) terminal device, an internet of things (internet of things, IoT) terminal device, a wireless terminal device in industrial control (industrial control), a wireless terminal device in self driving (self driving), a wireless terminal device in remote medical (remote medical), a wireless terminal device in a smart grid (smart grid), a wireless terminal device in transportation safety (transportation safety), a wireless terminal device in a smart city (smart city), a wireless terminal device (for example, a game console, a smart television, a smart speaker, a smart refrigerator, or fitness equipment) in a smart home (smart home), or a vehicle-mounted terminal device.

### (1.2) Access network device:

The access network device may be a base station (base station), an evolved NodeB (evolved NodeB, eNodeB), an access point (access point, AP), a transmission reception point (transmission reception point, TRP), a next generation NodeB (next generation NodeB, gNB), a next generation base station in a 6G mobile communication system, a base station in a future mobile communication system, an access node in a Wi-Fi system, or the like. The access network device may be a macro base station, a micro base station, an indoor base station, a relay node, or a donor node, or a radio controller in an open access network (open RAN, O-RAN, or ORAN) or a cloud radio access network (cloud radio access network, CRAN) scenario. Optionally, the access network device may alternatively be a server, a wearable device, a vehicle, a vehicle-mounted device, or the like. For example, an access network device in a vehicle to everything (vehicle to everything, V2X) technology may be a road side unit (road side unit, RSU). All or some functions of the access network device in this application may alternatively be implemented by using a software function running on hardware, or may be implemented by using an instantiated virtualization function on a platform (for example, a cloud platform). The access network device in this application may alternatively be a logical node, a logic module, or software that can implement all or some functions of the access network device.

In another possible scenario, a plurality of access network devices cooperate to assist the terminal device in implementing radio access, and different access network devices separately implement some functions of a base station. For example, the access network device may be a central unit (central unit, CU), a distributed unit (distributed unit, DU), a CU-control plane (control plane, CP), a CU-user plane (user plane, UP), a radio unit (radio unit, RU), or the like. The CU and the DU may be separately arranged, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH).

In different systems, the CU (or the CU-CP and the CU-UP), the DU, or the RU may also have different names, but a person skilled in the art may understand meanings thereof. For example, in an ORAN system, the CU may also be referred to as an O-CU (open CU), the DU may also be referred to as an O-DU, the CU-CP may also be referred to as an O-CU-CP, the CU-UP may also be referred to as an O-CU-UP, and the RU may also be referred to as an O-RU. For ease of description, the CU, the CU-CP, the CU-UP, the DU, and the RU are used as examples for description in this application. Any one of the CU (or the CU-CP or the CU-UP), the DU, and the RU in this application may be implemented by using a software module, a hardware module, or a combination of a software module and a hardware module.

In embodiments of this application, the functions of the access network device may alternatively be executed by a module (for example, a chip) in the access network device, or may alternatively be executed by a control subsystem including the functions of the access network device. The control subsystem including the functions of the access network device may be a control center in the foregoing application scenarios such as the smart grid, the industrial control, the smart transportation, and the smart city. A function of the terminal device may alternatively be performed by a module (for example, a chip or a modem) in the terminal device, or may be performed by an apparatus including a terminal function.

### (2) CN200:

The CN 200 may include a plurality of core network elements, and the radio access network device may be connected to the core network element in a wireless or wired manner. The core network element and a radio access network device may be different physical devices that are independent of each other, functions of the core network element and logical functions of the radio access network device may be integrated into a same physical device, or some functions of the core network element and some functions of the radio access network device may be integrated into one physical device.

In an example of a 5G communication system, the core network element in the CN 200 may include an access and mobility management function (access and mobility management function, AMF) network element, a session management function (session management function, SMF) network element, a user plane function (user plane function, UPF) network element, a policy control function (policy control function, PCF) network element, an application function (application function, AF) network element, and the like. For specific descriptions of the foregoing core network elements, refer to related technical specifications of 3GPP.

### (3) DN300:

The DN 300 may also be referred to as a packet data network (packet data network, PDN), and is a network located outside an operator network. An application server corresponding to a plurality of services may be deployed in the DN 300, to provide a plurality of possible services for the terminal device.

It may be understood that solutions in embodiments of this application may be applicable to a plurality of possible communication systems, for example, a 5G communication system or a future 6G communication system. The foregoing network elements or functions may be network elements in a hardware device, may be software functions running on dedicated hardware, or may be virtualized functions instantiated on a platform (for example, a cloud platform). In addition, FIG. 1 is merely a diagram. The RAN of the communication system may further include another access network device, for example, may further include a wireless relay device and a wireless backhaul device.

In the network architecture shown in FIG. 1, a user plane data transmission channel may be established for the terminal device through a control plane signaling exchange procedure (for example, a protocol data unit (protocol data unit, PDU) session establishment procedure), so that the terminal device may perform data transmission with an application server deployed in the DN through the user plane data transmission channel. For example, the application server may send a downlink data packet to the terminal device, and a transmission path of the downlink data packet is: application server → UPF network element → access network device → terminal device. Correspondingly, the terminal device may send an uplink data packet to the application server, and a transmission path of the uplink data packet is: terminal device → access network device → UPF network element → application server.

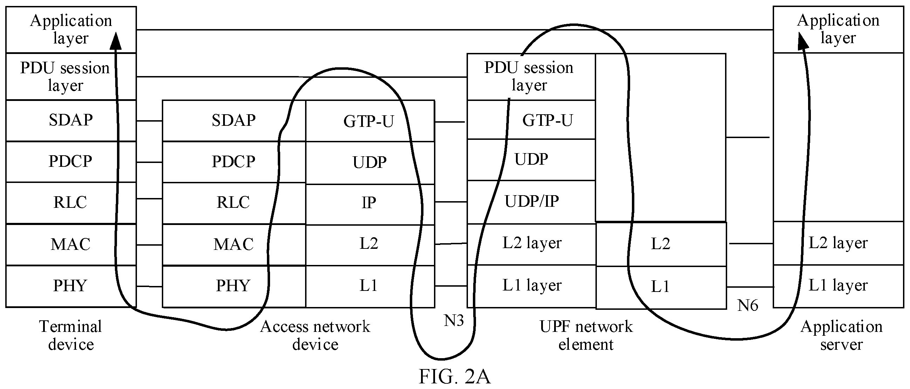

FIG. 2A is an example diagram of a structure of a protocol layer. As shown in FIG. 2A, an access network protocol layer structure may be followed between a terminal device and an access network device. For descriptions of an access stratum protocol layer structure, refer to the following. A protocol layer structure between the access network device and a UPF network element may include a layer L1 (that is, a physical layer), a layer L2 (that is, a data link layer), a user datagram protocol (user datagram protocol, UDP) layer, an internet protocol (internet protocol, IP) layer, a general packet radio service (general packet radio service, GPRS) tunneling protocol (GPRS tunnel protocol, GTP)-user plane (GTP-U) layer, and the like. In addition, the UPF network element may further include a PDU session layer that is equivalent to a PDU session layer of the terminal device. A protocol layer structure between the UPF network element and an application server may include a layer L1 and a layer L2, and further include another layer. For details, refer to an existing protocol. In addition, the application server may further include an application layer that is equivalent to an application layer of the terminal device.

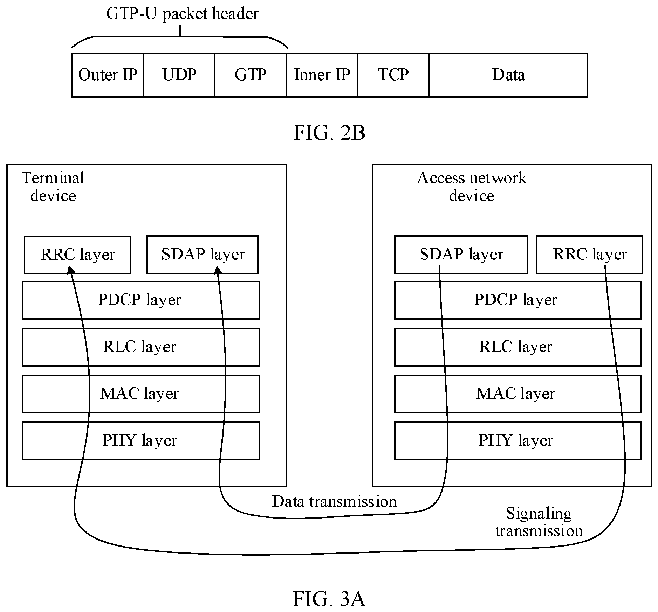

The access network device may receive a GTP-U data packet from the UPF network element through an NG interface (which may also be referred to as an N3 interface or an NG-U tunnel). For example, as shown in FIG. 2B, the GTP-U data packet includes a GTP-U packet header, an inner IP (inner IP) packet header, a TCP packet header, and data; and the GTP-U packet header includes an outer IP (outer IP) packet header, a UDP packet header, and a GTP packet header.

The following describes a protocol layer structure between the access network device and the terminal device.

The access network protocol layer structure between the access network device and the terminal device may include a control plane protocol layer structure and a user plane protocol layer structure. The foregoing FIG. 2A is illustrated by using an example of the user plane protocol structure. For example, the control plane protocol layer structure may include a radio resource control (radio resource control, RRC) layer, a packet data convergence protocol (packet data convergence protocol, PDCP) layer, a radio link control (radio link control, RLC) layer, a media access control (media access control, MAC) layer, and a physical layer (physical layer, PHY). The user plane protocol layer structure may include a PDCP layer, an RLC layer, a MAC layer, and a physical layer. In a possible implementation, a service data adaptation protocol (service data adaptation protocol, SDAP) layer may be further included above the PDCP layer. The SDAP layer, the PDCP layer, the RLC layer, the MAC layer, and the physical layer may also be collectively referred to as an access stratum. It can be learned from FIG. 2A that the terminal device further includes a non-access stratum, for example, the PDU session layer or the application layer. For detailed descriptions of the foregoing protocol layers, refer to related technical specifications of the 3^{rd} generation partnership project (3^{rd} generation partnership project, 3GPP).

When the access network device and the terminal device perform user plane data transmission, data needs to pass through a user plane protocol layer, for example, through the SDAP layer, the PDCP layer, the RLC layer, the MAC layer, and the physical layer. For example, at least one data radio bearer (data radio bearer, DRB) is established between the access network device and the terminal device for data transmission. Each DRB may correspond to a group of functional entity sets. For example, the functional entity set may include one PDCP layer entity, at least one RLC layer entity corresponding to the PDCP layer entity, at least one MAC layer entity corresponding to the at least one RLC layer entity, and at least one physical layer entity corresponding to the at least one MAC layer entity.

Downlink data transmission is used as an example. FIG. 3A shows transmission of downlink data between layers. As shown in FIG. 3A, from a perspective of an access network device, after obtaining the data, an SDAP layer entity of the access network device may map, based on a quality of service (quality of service, QoS) flow identifier (QoS flow indicator, QFI) of the data, the data to a PDCP layer entity of a corresponding DRB. The PDCP layer entity may transmit the data to at least one RLC layer entity corresponding to the PDCP layer entity, then the at least one RLC layer entity transmits the data to a corresponding MAC layer entity, then the MAC layer entity generates a transport block, and a corresponding physical layer entity performs wireless transmission, to send the transport block to a terminal device.

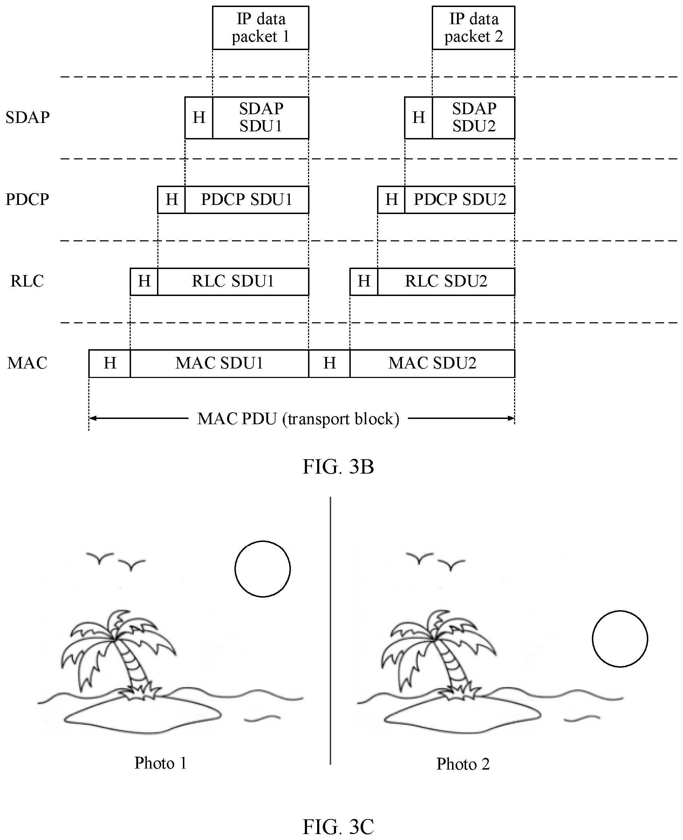

The downlink data may be correspondingly encapsulated at each layer of the access network device. Data received by a layer from an upper layer of the layer is considered as a service data unit (service data unit, SDU) of the layer, is encapsulated at the layer into a PDU, and is then transmitted to a next layer. For example, as shown in FIG. 3B, data received by the PDCP layer entity from an SDAP layer may be referred to as a PDCP SDU, and after encapsulating the PDCP SDU (for example, adding a PDCP layer packet header), the PDCP layer entity obtains a PDCP PDU and sends the PDCP PDU to an RLC layer. A PDCP PDU received by the RLC layer entity from a PDCP layer may be referred to as an RLC SDU, and after encapsulating the RLC SDU (for example, adding an RLC layer packet header), the RLC layer entity obtains an RLC PDU and sends the RLC PDU to a MAC layer. After receiving the RLC PDU, the MAC layer may encapsulate one or more RLC PDUs (and RLC PDU segments) into one MAC PDU, where the MAC PDU may also be referred to as the transport block, and the transport block is sent to a physical layer. After receiving the transport block, the physical layer may add verification information, for example, cyclic redundancy check (cyclic redundancy check, CRC), to the transport block, and send the transport block to the terminal device. Data may be transmitted between different layers through a corresponding channel. For example, data may be transmitted between the RLC layer entity and the MAC layer entity through a logical channel (logical channel, LCH), and data may be transmitted between the MAC layer entity and the physical (PHY) layer entity through a transport channel (transport channel).

When the access network device and the terminal device perform control plane signaling transmission, signaling needs to pass through a control plane protocol layer, for example, through an RRC layer, the PDCP layer, the RLC layer, the MAC layer, and the physical layer. For example, at least one signaling radio bearer (signaling radio bearer, SRB) is established between the access network device and the terminal device for signaling transmission. The SRB and the DRB may be collectively referred to as a radio bearer (radio bearer, RB).

An example in which the access network device sends RRC signaling to the terminal device is used. The RRC signaling may also be referred to as an RRC message. FIG. 3A is a diagram of transmission of an RRC message between layers. As shown in FIG. 3A, from a perspective of the access network device, after generating the RRC message, the RRC layer entity of the access network device may transfer the RRC message to a PDCP layer entity of a corresponding SRB. The PDCP layer entity may transmit the RRC message to at least one RLC layer entity corresponding to the PDCP layer entity, then the at least one RLC layer entity transmits the RRC message to a corresponding MAC layer entity, then the MAC layer entity generates a transport block, and a corresponding physical layer entity performs wireless transmission, to send the transport block to the terminal device.

From a perspective of the terminal device, after a physical layer of the terminal device receives the transport block from the access network device, the transport block may be sequentially transferred from the physical layer to upper layers, and may be correspondingly decapsulated at each layer. In other words, processing performed at each layer of the terminal device may be an inverse process of processing performed at each layer of the access network device.

The network architecture and the service scenario that are described in embodiments of this application are intended to describe the technical solutions in embodiments of this application more clearly, and do not constitute a limitation on the technical solutions provided in embodiments of this application. A person of ordinary skill in the art may know that, with evolution of the network architecture and emergence of a new service scenario, the technical solutions provided in embodiments of this application are also applicable to a similar technical problem.

For better understanding of the solutions in embodiments of this application, the following first describes related technical features and names in embodiments of this application. It should be noted that, these explanations are intended to make embodiments of this application easier to understand, but should not be construed as a limitation on the scope of protection claimed in this application.
1. Semantic communication: Different from a conventional communication system, where a main task of the conventional communication system is to achieve accurate transmission of bit-level or symbol-level information, and a bit error rate (bit error rate, BER) or a symbol error rate (symbol error rate, SER), therefore, is a main performance indicator of the conventional communication system, a semantic communication system focuses on how a transmitted symbol accurately conveys an intended meaning. An application that can be supported by the semantic communication may include a service that has a large quantity of data and has a high requirement on a data delay, for example, a high-precision voice or a high-definition video.
2. Semantic error tolerance service: May also be referred to as an error tolerance service. The semantic error tolerance service may refer to a service in which decoding of a source or an application layer has an error tolerance capability, that is, the source or the application layer can perform correct content restoration based on incorrect data. The incorrect data may refer to data that has a transmission error (for example, some data is lost during transmission), or data in which some decoding fails or a decoding error occurs during decoding.

Alternatively, the semantic error tolerance service may also be a service in which forward error correction (forward error correction, FEC) is added at the application layer. Due to existence of the FEC, even if received data has the transmission error, in some scenarios, for example, a quantity of transmitted error bits is small and is still within an error correction capability range, the application layer may perform error correction on error data by using the FEC, to restore correct content.

Alternatively, the semantic error tolerance service may be a service that uses artificial intelligence (artificial intelligence, AI) decoding. From a perspective of information theory, an AI decoding model can provide additional information entropy. Therefore, although some information entropy is lost in incorrectly transmitted data, the lost information entropy can still be compensated for through AI decoding, so that information content can be correctly restored.

It should be noted that the "semantic error tolerance service" is merely an example name, and a name of this type of service is not limited in this application. In specific implementation, any service that can perform correct decoding based on an error data packet may be understood as the semantic error tolerance service in this application.

3. Error tolerance capability: In semantic communication, some current video applications add forward error correction (forward error correction, FEC) to an application layer to provide an error tolerance capability. The error tolerance capability may be understood as follows: A transmitting end encodes an original information vector A into a latent representation vector B in a specified semantic feature domain (semantic feature domain). Through air interface transmission, a latent representation vector received by a receiving end is B', and B ≠ B'. However, in the foregoing semantic feature domain, a Hamming distance between the latent representation vector B' received by the receiving end and the latent representation vector B of the transmitting end does not exceed a specified threshold ε, and the receiving end may decode the received latent representation vector B' into A' through decoding, and A' = A. In this case, the foregoing error tolerance capability may be quantized as ε.

In embodiments of this application, the error tolerance capability of data may be further understood as but is not limited to one or more of the following:

### (1) supporting obtaining or generating, based on a preset quantity of data packets, a frame to which the data belongs

For example, using photo data as an example, obtaining or generating, based on a preset quantity of data packets, a photo of a frame to which the data belongs is supported.

### (2) supporting correcting a preset quantity of data packets in the data

For example, using photo data as an example, an error tolerance capability of the data may refer to supporting correcting a preset quantity of error data packets.

### (3) supporting obtaining or generating, when a data packet that is incorrectly decoded is within a preset quantity range, a frame to which the data belongs

For example, using photo data as an example, an error tolerance capability of the data may refer to supporting obtaining or generating, when a data packet that is incorrectly decoded is within a preset quantity range, a photo of the frame to which the data belongs.

4. Entropy estimated value: May also be referred to as an entropy value, information entropy, or the like. In information theory, the entropy estimated value reflects uncertainty of information. A larger entropy estimated value of service data indicates a larger quantity of information. On the contrary, a smaller entropy estimated value indicates a smaller quantity of information.

5. Context information: In the real world, a target cannot exist independently, and certainly has some association or relationships with another surrounding object. This is usually referred to as context information. The context information may usually be understood as sensing and being able to use some or all information that can affect an object in a scenario and an object in an image.

Interaction information between different objects and interaction information between an object and a scenario are captured as conditions, so that a new target is identified and processed. The context information is not directly obtained from an appearance of the target, but is obtained from data in a neighboring domain, an annotation of the target, a spatial position of the target, or data statistics information.

Using photos as an example of data, the context information may include correlations between the photos and correlations within the photos, and the correlations between the photos and the correlations within the photos may include but are not limited to a time correlation and/or a spatial correlation (which are/is equivalent to a correlation in a time dimension and/or a spatial dimension).

For example, target data including two frames of photos is used as an example. The two frames of photos are a photo 1 and a photo 2 in FIG. 3C. In a picture of the photo 1, target objects include an ocean, a land, a tree, birds, and the sun, and a background is the sky. There is specific association between these target objects and between the target objects and the background in a spatial dimension and/or time dimension. In other words, the association may be referred to as correlation information in the photo 1. The same applies to the photo 2.

If the photo 1 is a current frame of photo, and the photo 2 is a next frame of photo, there is a spatial correlation between two photos. For example, a position of the target object (for example, the ocean, the land, the tree, the birds, or the sun) in the photo 1 is correlated with a position of a target object (for example, an ocean, a land, a tree, birds, or the sun) in the photo 2. Time shown in the picture of the photo 1 also has a correlation with time shown in a picture of the photo 2. For example, pictures shown in the photo 1 and the photo 2 correspond to different time within a same time period, and the time of the photo 2 is later than the time of the photo 1. Therefore, based on the picture shown in the photo 1 and the time correlation between the two photos, it may be inferred that a position of the sun in the photo 2 is lower than a position of the sun in the photo 1.

Therefore, context information of the target data may include the correlation information in the photo 1, correlation information in the photo 2, and correlation information between the photo 1 and the photo 2.

6. Group of pictures (GOP): Frame sequences in a moving pictures experts group (moving pictures experts group, MPEG) format are classified into three types: I, P, and B, for example, arranged in an IBBPBBPBBPBBIPBBP... style. Such a combination of consecutive frames of photos is a group of pictures (group of pictures, GOP), which is the most basic unit for MPEG access in the future. The arrangement sequence thereof repeats until the end of an image. One GOP is a group of consecutive IPB pictures. In MPEG coding, pictures (frames) are classified into three types: I, P, and B. I is an intra-coded frame, P is a forward-predicted frame, and B is a bidirectional-interpolated frame. Simply, an I-frame is a key frame, and may be understood as a complete picture. A P-frame and a B-frame record changes relative to the I-frame. The P-frame indicates a difference between a current frame and a next frame (also referred to as a forward frame), and the B-frame indicates a difference between a previous frame and a next frame. If there is no I-frame, the P-frame and B-frame cannot be decoded. This is why the MPEG format cannot be accurately edited and why fine-tuning a head and tail is necessary. A longer I-frame (key frame) interval indicates a longer GOP, and theoretically indicates a higher picture definition.

In this embodiment of this application, one group of pictures GOP is a group of consecutive pictures. In this case, a feature data stream obtained by performing feature extraction on the group of pictures GOP is a long string of data. During actual transmission, a plurality of IP packets may be needed for carrying, for example, a length of the IP packet is limited.

### 7. Current source coding and channel coding technologies:

In current communication, to ensure reliability and efficiency of data or information transmission, a transmitting end usually performs encoding processing on to-be-sent data or information, and a receiving end performs decoding processing after receiving the to-be-sent data or information.

Artificial intelligence AI-based source coding: Semantic application is widely used in source coding scenarios, for example, photo coding and video coding, which may usually be collectively referred to as AI-based source coding. The following uses deep contextual video compression-diverse contexts (deep contextual video compression-diverse contexts, DCVC-DC) (video coding) as an example to describe a method for performing semantic extraction and optimizing source coding by using AI, and the method has a better compression effect than a current adaptive coding manner.

For a current video codec, there are problems that a data dimension is too large, and it is difficult to manually formulate a clear rule to use a correlation. The DCVC-DC proposes use of a deep learning method to perform conditional coding, that is, a current frame is directly encoded based on a predicted frame or context information, to reduce an entropy limit. In other words, associated context information is determined from a previously reconstructed signal, and the associated context information is applied to current encoding and decoding, so that coding efficiency (or compression efficiency) can be improved.

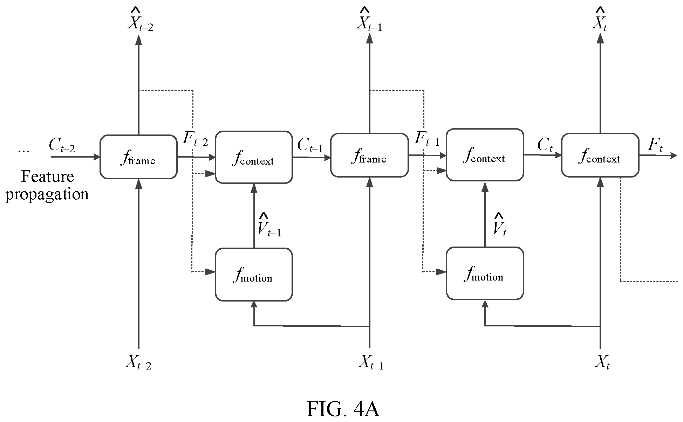

As shown in FIG. 4A, DCVC-DC uses a learnable context feature/learnable context information as a condition to replace a predicted frame. The context feature or a context (for example, *C*_{*t*-2}, *C*_{*t*-1}, and *Cₜ* shown in FIG. 4A) usually represents time and spatial correlations within a photo and between photos, and may be used as a part of an input of a context encoder, a context decoder, and an entropy model. Further, to effectively capture information at different layers, for example, a texture, a structure, a color, and a motion in a video frame, and to effectively process a problem that object sizes are different in different resolutions, the context feature (or the context) is adjusted to a plurality of scales, so that the DCVC-DC can use a higher-layer network (the higher-layer network has a large receptive field and a strong semantic information representation capability) and a lower-layer network (the lower-layer network has a high resolution of a feature map and a strong geometric information representation capability), to obtain context features (or contexts) of different sizes. In addition, to obtain rich long-term and high-quality time domain contexts, a cross-frame hierarchical quality mode is used to periodically generate high-quality output frames and features containing many high-frequency details. A feature propagation chain is formed through cross-frame cascading training, so that the high-quality contexts are kept within a long range.

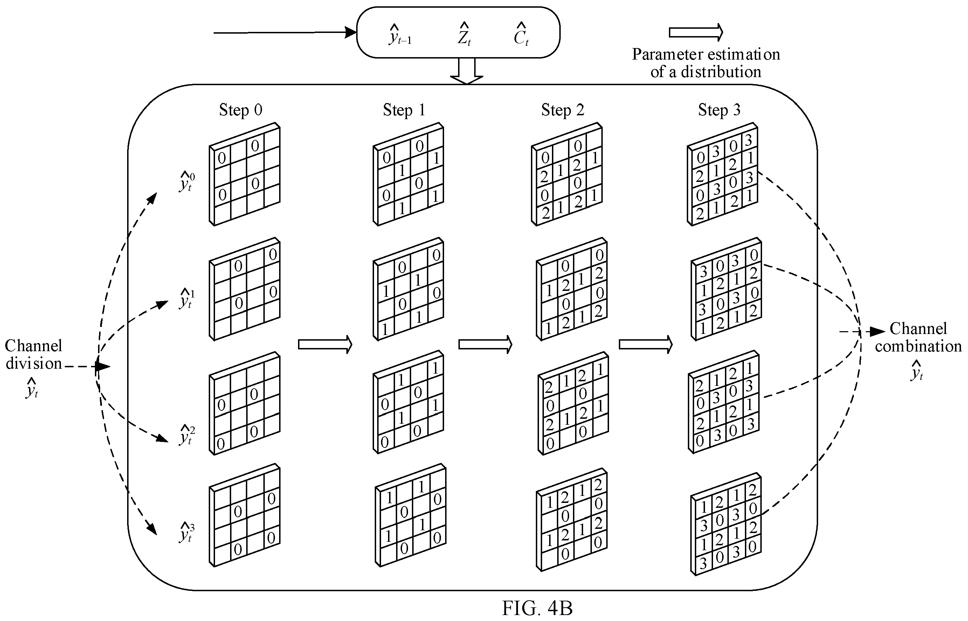

In addition, as shown in FIG. 4B, the DCVC-DC supports use of a quadtree partitioning-based entropy model, so that during entropy coding, diverse spatial contexts can be better used to remove intra-frame spatial redundancy. Specifically, a feature is divided into four groups along a channel dimension. As shown in FIG. 4B, *ŷₜ* is divided (or copied) into ${\hat{y}}_{t}^{0} , {\hat{y}}_{t}^{1}$, ${\hat{y}}_{t}^{2}$, and ${\hat{y}}_{t}^{3}$, and each group is spatially divided into non-overlapping 2 × 2 blocks. The entire entropy coding is divided into four steps. In each step, for the four groups, blocks at different positions but with a same number are encoded, and a probability distribution of positions at which encoding is already performed in a current step may be predicted based on all positions at which encoding is already performed in a previous step, so as to fully utilize a spatial context and perform parallel (concurrent) processing, and a training speed is faster and an encoding and decoding speed is faster.

In conclusion, in AI-based source coding using the DCVC-DC as an example, a cross-frame context is constructed, and multi-channel feature encoding is performed by using the context, so that compression efficiency is higher; and a receiving end performs decoding based on the same context, so that decoding efficiency is higher.

Entropy model-based semantic communication: When an entropy model is used in source coding, a compression gain can be improved. Use of the entropy model in channel coding is proposed. In a semantic communication framework based on joint source and channel coding (joint source and channel coding, JSCC), a scheduling method that may be used is as follows:
Step 1: An application layer (or a source) performs semantic extraction on an original image x, assumes that semantic information is marked as a vector y, and performs entropy estimation extraction on the vector y.
Step 2: Guide physical layer channel coding and adaptive transmission by compromising data importance, redundancy, and a channel transmission capability. For example, during transmission, more bandwidth, a lower bit rate, and the like are allocated to data with a higher entropy estimated value.

Specifically, at a transmitting end, for source information, for example, the original image x, the semantic information is extracted based on a type of a source with reference to a semantic information coding technology. The semantic information (the vector y) and transmission environment status information are input into a joint source and channel coding module. Based on a trained deep learning model, joint source and channel coding is performed on the foregoing data information, and the data information is sent to a physical channel for bit data transmission.

A corresponding receiver model is constructed at a receiving end. For example, the receiver model may include a joint source and channel decoder and a semantic decoder. First, an access end may decode received bit data information based on the trained joint source and channel decoder with reference to current channel state information, to obtain corresponding semantic encoding information. The receiving end inputs the semantic coding information into the semantic decoder, and obtains the corresponding semantic information and key feature extraction information through decoding. The receiving end checks the semantic information. If information check passes, it indicates that source information is correctly transmitted; or if information check fails, repair is performed by using key feature information, or all source information is triggered to be resent, or some source information is resent. When all segmented semantic information is obtained through decoding, the entire semantic information is restored according to a segmentation manner.

It can be learned from the foregoing related descriptions of the existing coding technology that, in AI-based semantic source coding, the receiving end and the transmitting end maintain the same context to perform source encoding and decoding, to implement high-quality compression, and use of the context in channel coding is not considered. The entropy model-based semantic communication proves that expanding an object of coding optimization from the source to the channel can bring further gains.

In view of the foregoing, embodiments of this application provide a communication method. In the method, channel encoding of data is implemented based on context information of the data, so that data transmission performance can be effectively improved.

The communication method provided in embodiments of this application may relate to interaction between two apparatuses. The two apparatuses are, for example, a first apparatus and a second apparatus. The first apparatus may be used as a transmitting end or a receiving end, and the second apparatus may also be used as a transmitting end or a receiving end. For example, when the first apparatus is used as the transmitting end, the second apparatus is used as the receiving end; or when the second apparatus is used as the transmitting end, the first apparatus is used as the receiving end. In the following, an example in which the first apparatus is the transmitting end and the second apparatus is the receiving end is used to describe the solutions in embodiments of this application.

For example, in the communication system shown in the foregoing FIG. 1, the first apparatus may be an access network device, and the second apparatus may be a terminal device; or the first apparatus may be a terminal device, and the second apparatus may be an access network device. In embodiments of this application, unless otherwise specified, the "terminal device" may refer to the terminal device, or may refer to a component in the terminal device, for example, a chip or a chip system; and the "network device (including the access network device)" may refer to the network device, or may refer to a component in the network device, for example, a chip or a chip system.

The following correspondingly describes the solutions in embodiments of this application.

Embodiments of this application provide a communication method. The method is applicable to but is not limited to being applicable to the communication system shown in FIG. 1. The method may be executed by a first apparatus and a second apparatus; or the method may be executed by components (modules, chips, and the like) corresponding to the first apparatus and the second apparatus; or the method may be executed by an apparatus that is correspondingly used in conjunction with the first apparatus and the second apparatus. It may be understood that a specific structure of an execution body of the method provided in embodiments of this application and a quantity of execution bodies are not specifically limited in this application, provided that a program that records code of the method provided in embodiments of this application can be run to perform communication according to the method provided in embodiments of this application. The following uses interaction between the first apparatus and the second apparatus as an example for description. A sequence of steps in the following procedures is merely an example. During actual application, the sequence of steps in each procedure may be adjusted.

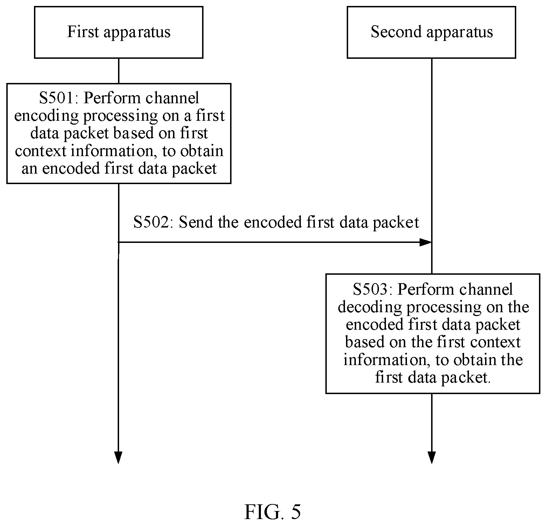

Refer to FIG. 5. A specific procedure of the method is as follows:
S501: A first apparatus performs channel encoding processing on a first data packet based on first context information, to obtain an encoded first data packet.

The first context information is associated with first data having a first error tolerance capability, the first data includes N data packets, the first data packet is any one of the N data packets, and N is a positive integer. The first context information may indicate time association and/or spatial association between two frames, and the first error tolerance capability indicates that a frame to which the first data belongs can be obtained based on a preset quantity of data packets.

Using photo-type data as an example, the context information may indicate time association and/or spatial association between two adjacent frames of photos. For ease of description, the two adjacent frames are referred to as a current frame and a next frame herein. Time information and/or spatial information of a next frame of photo may be deduced or predicted by using time information and/or spatial information of a current frame of photo and the context information (the time association and/or spatial association between the current frame and the next frame). Time information: A target between adjacent frames does not change greatly, and a position does not change abruptly. Spatial information: A specific relationship exists between a target and a background around the target. When an appearance of the target changes greatly, the relationship can help distinguish the target from the background.

For example, the first data is the photo-type data. The first data may be a frame of photo or an area in the frame of photo. The first data may include a plurality of data packets. An error tolerance capability of the first data packet may mean that the frame of photo or the area in the frame of photo is supported to be obtained or generated based on a specific quantity (or a preset quantity) of data packets in the plurality of data packets. In a possible implementation, a smaller quantity of data packets based on which the frame of photo or the area in the frame of photo corresponding to the first data is generated indicates a stronger error tolerance capability of the first data, and a larger quantity of data packets based on which the frame of photo or the area in the frame of photo corresponding to the first data is generated indicates a weaker error tolerance capability of the first data. In this embodiment of this application, the error tolerance capability of the first data may be further understood as an error correction capability or a restoration capability of the data. In a possible implementation, the error correction capability of the first data may mean that an error of a specific quantity of data is supported to be corrected when the frame of photo to which the first data belongs is restored/generated.

In the foregoing, the first data is used as an example to describe the context information and the error tolerance capability, which are not only for the first data, and are applicable to all other data similar to the first data.

In this embodiment of this application, in a network communication scenario, the first apparatus may be an access network device, a terminal device, a core network device, or the like. The second apparatus may be an access network device, a terminal device, a core network device, or the like. In some embodiments, the first apparatus and the second apparatus may be devices or apparatuses deployed independently of each other, or may be integrated or deployed in a same device or apparatus. This is not limited herein.

In a possible implementation, that the first apparatus performs channel encoding processing on the first data packet of the N data packets based on the first context information, to obtain the encoded first data packet may include the following steps:
**Step 1:** The first apparatus respectively performs channel encoding processing on M first data packets based on the first context information by using M encoding methods, to obtain M encoded data packets. The M first data packets may be obtained by the first apparatus in a manner like copying the first data packet, the M encoding methods are in one-to-one correspondence with the M first data packets (that is, the M encoding methods may be used to encode the M first data packets in one-to-one correspondence, to obtain the corresponding encoded data packets), and M is an integer greater than 1.

In a possible implementation, that the first apparatus respectively performs channel encoding processing on the M first data packets based on the first context information by using the M encoding methods, to obtain the M encoded data packets includes: first obtaining channel state information (channel state information, CSI); and then performing channel encoding processing on the M first data packets based on the first context information and the channel state information CSI by using the M encoding methods, to obtain the M encoded data packets. In this embodiment of this application, the first apparatus may obtain the channel state information CSI after performing measurement with reference to an existing channel measurement procedure, or obtain the channel state information CSI in another manner. This is not limited herein.

In this embodiment of this application, a correspondence between the foregoing M encoding methods and the M first data packets may be a one-to-one relationship. In a possible implementation, a correspondence between K encoding methods and the M first data packets may not be a one-to-one relationship, where K is equal to M or K is a positive integer not equal to M. For example, the correspondence between the K encoding methods and the M first data packets may include at least one of a one-to-one relationship, a one-to-many relationship, and a many-to-one relationship. How to match the K encoding methods and the M first data packets to implement the solution may be flexibly set based on an actual requirement. This is not specifically limited.

**Step 2:** The first apparatus performs combination processing on the M encoded data packets, to obtain the encoded first data packet.

In this embodiment of this application, the foregoing implementation of combination processing may include but is not limited to that the first apparatus may use the M encoded data packets as an input of a neural network, and an output of the neural network is the encoded first data packet, where a parameter (for example, a weight on a neuron line) of the neural network may be obtained in advance through training. Alternatively, the first apparatus may obtain the encoded first data packet based on the M encoded data packets by using a maximum likelihood method.

In a possible implementation, the first apparatus includes a first protocol layer and a second protocol layer. In this case, the first apparatus may perform the foregoing step 1 at the first protocol layer or the second protocol layer, and may perform the foregoing step 2 at the second protocol layer.

If the foregoing step 1 is performed at the first protocol layer, and step 2 is performed at the second protocol layer, the first data packet may be first copied at the first protocol layer or an upper layer of the first protocol layer, to obtain the M first data packets. Then, the foregoing step 1 is performed at the first protocol layer, to obtain the M encoded data packets. Further, the M encoded data packets may be sent to the second protocol layer through M channels between the first protocol layer and the second protocol layer, so that step 2 is performed at the second protocol layer. The M encoded data packets may be in one-to-one correspondence with the M channels.

If both the foregoing step 1 and step 2 are performed at the second protocol layer, the first data packet may be first copied at the first protocol layer, to obtain the M first data packets. Then, the M first data packets are sent to the second protocol layer, so that the foregoing step 1 and step 2 are performed at the second protocol layer.

In this embodiment of this application, the first protocol layer may be but is not limited to any one of a packet data convergence protocol PDCP layer, a radio link control RLC layer, a media access control MAC layer, and a physical PHY layer. The second protocol layer may be but is not limited to any one of a packet data convergence protocol PDCP layer, a radio link control RLC layer, a media access control MAC layer, and a physical PHY layer.

For example, if the first protocol layer is the PDCP layer, the second protocol layer may be any one of the radio link control RLC layer, the media access control MAC layer, and the physical PHY layer. If the first protocol layer is the RLC layer, the second protocol layer may be either the media access control MAC layer or the physical PHY layer. If the first protocol layer is the MAC layer, the second protocol layer may be the physical PHY layer.

For example, on a first apparatus side, the first data packet is first copied at the PDCP layer, to obtain the M first data packets; the M first data packets are sent to the RLC layer, and channel encoding is performed on the M first data packets at the RLC layer by using the M encoding methods, to obtain the M encoded data packets; the M encoded data packets are sent to the MAC layer through the M channels; and combination processing is performed on the M encoded data packets at the MAC layer, to obtain the encoded first data packet.

It should be noted that, with a change or evolution of an application scenario and/or a transmission protocol structure, some or all of the PDCP layer, the RLC layer, the MAC layer, and the PHY layer may be correspondingly replaced with other layers or may be renamed. The channel encoding manner in the solutions of this application is also applicable provided that there is a transmission channel/path between two layers, two levels, or two entities.

In a possible implementation, the foregoing M encoding methods may be in one-to-one correspondence with the M channels between the first protocol layer and the second protocol layer.

In this embodiment of this application, that the M encoding methods are in one-to-one correspondence with the M channels between the first protocol layer and the second protocol layer may be understood as that the M encoding methods are in one-to-one correspondence with and used in conjunction with the M channels. In a possible implementation, to ensure transmission efficiency and reliability, the M encoding methods are selected or set based on channel state information CSI of the M channels.

In this embodiment of this application, the used encoding method may be an encoding method obtained through evolution based on an encoding method, for example, AI code, low-density parity-check code (low-density parity-check code, LDPC), or polar code. This is not limited herein.

In another possible implementation, a correspondence between the K encoding methods and the M channels may not be one-to-one, where K is equal to M or K is a positive integer not equal to M. For example, the correspondence between the K encoding methods and the M channels includes one or more of a one-to-one relationship, a many-to-one relationship, and a one-to-many relationship.

S502: The first apparatus sends the encoded first data packet to the second apparatus. Correspondingly, the second apparatus receives the encoded first data packet.

In a possible implementation, the encoded first data packet carries first indication information, and the first indication information indicates that the encoded first data packet is associated with the first data.

In a possible implementation, the first indication information may further indicate the first error tolerance capability corresponding to the first data.

In this embodiment of this application, S501 and S502 are described by using the first data packet in the first data as an example. During actual application, there may be a plurality of data packets in the first data, and the first apparatus may perform channel encoding on each data packet with reference to the foregoing S501. In a possible implementation, in S502, for a plurality of encoded data packets corresponding to the first data, the first apparatus may perform scheduling by using one or more transport blocks (multi-TB), that is, the plurality of encoded data packets may be sent to the second apparatus in parallel (concurrently) by using the one or more transport blocks. For other data similar to the first data, encoding processing may be performed with reference to the encoding manner corresponding to the first data. Details are not described herein again.

S503: The second apparatus performs channel decoding processing on the encoded first data packet based on the first context information, to obtain the first data packet.

In a possible implementation, the method further includes: The second apparatus obtains the first context information. That the second apparatus obtains the first context information may be implemented but is not limited to being implemented in the following manners:
Manner 1: The second apparatus receives the first context information from the first apparatus.
Manner 2: The second apparatus extracts initial first feature data based on a preset model, to obtain context information, and updates the context information based on the current encoded first data packet, to obtain the first context information.

In a possible implementation, that the second apparatus performs channel decoding processing on the encoded first data packet based on the first context information, to obtain the first data packet may include the following steps:
**Step 1:** The second apparatus respectively performs channel decoding processing on M encoded first data packets based on the first context information by using M decoding methods, to obtain M decoded data packets. The M encoded first data packets may be obtained by a second communication apparatus in a manner like copying the encoded first data packet, the M decoding methods are in one-to-one correspondence with the M encoded first data packets (that is, the M decoding methods may be used to decode the M encoded first data packets in one-to-one correspondence, to obtain the corresponding decoded data packets), and M is an integer greater than 1.

In a possible implementation, that the second apparatus respectively performs channel decoding processing on the M encoded first data packets based on the first context information by using the M decoding methods, to obtain the M decoded data packets includes: first obtaining channel state information CSI, and then performing channel decoding processing on the M encoded first data packets based on the first context information and the channel state information CSI by using the M decoding methods, to obtain the M decoded data packets. In this embodiment of this application, the second apparatus may obtain the channel state information CSI after performing measurement with reference to an existing channel measurement procedure, or obtain the channel state information CSI in another manner. This is not limited herein.

In this embodiment of this application, a correspondence between the foregoing M decoding methods and the M encoded first data packets may be a one-to-one relationship. In a possible implementation, a correspondence between K decoding methods and the M encoded first data packets may not be a one-to-one relationship, where K is equal to M or K is a positive integer not equal to M. For example, the correspondence between the K decoding methods and the M encoded first data packets may include at least one of a one-to-one relationship, a one-to-many relationship, and a many-to-one relationship. How to match the K decoding methods and the M encoded first data packets to implement the solution may be flexibly set based on an actual requirement. This is not specifically limited.

**Step 2:** The second apparatus performs combination processing on the M decoded data packets, to obtain the first data packet.

In this embodiment of this application, the implementation of combination processing may include but is not limited to that the second apparatus may use the M decoded data packets as an input of a neural network, and an output of the neural network is the first data packet, where a parameter (for example, a weight on a neuron line) of the neural network may be obtained in advance through training. Alternatively, the second apparatus may obtain the first data packet based on the M decoded data packets by using a maximum likelihood method.

In a possible implementation, the second apparatus includes a first protocol layer and a second protocol layer. In this case, the second apparatus may perform the foregoing step 1 at the first protocol layer or the second protocol layer, and may perform the foregoing step 2 at the first protocol layer.

If the foregoing step 1 is performed at the second protocol layer, and step 2 is performed at the first protocol layer, the encoded first data packet may be first copied at the second protocol layer or a lower layer of the second protocol layer, to obtain the M encoded first data packets. Then, the foregoing step 1 is performed at the second protocol layer, to obtain the M decoded data packets. Then, the M decoded data packets may be sent to the first protocol layer through M channels between the first protocol layer and the second protocol layer, so that the foregoing step 2 is performed at the first protocol layer. The M decoded data packets may be in one-to-one correspondence with the M channels.

If both the foregoing step 1 and step 2 are performed at the first protocol layer, the encoded first data packet may be first copied at the second protocol layer, to obtain the M encoded first data packets. Then, the M encoded first data packets are sent to the first protocol layer, so that the foregoing step 1 and step 2 are performed at the first protocol layer.

For example, if the second protocol layer is a PHY layer, the first protocol layer may be any one of a MAC layer, an RLC layer, and a PDCP layer. If the second protocol layer is the MAC layer, the first protocol layer may be either the RLC layer or the PDCP layer. If the second protocol layer is the RLC layer, the first protocol layer may be the PDCP layer.

It should be noted that, with a change or evolution of an application scenario and/or a transmission protocol structure, some or all of the PDCP layer, the RLC layer, the MAC layer, and the PHY layer may be correspondingly replaced with other layers or may be renamed. The channel decoding manner in the solutions of this application is also applicable provided that there is a transmission channel/path between two layers, two levels, or two entities.

In a possible implementation, the foregoing M decoding methods may be in one-to-one correspondence with M channels between the first protocol layer and the second protocol layer.

In this embodiment of this application, that the M decoding methods are in one-to-one correspondence with the M channels between the first protocol layer and the second protocol layer may be understood as that the M decoding methods are in one-to-one correspondence with and used in conjunction with the M channels. In a possible implementation, to ensure transmission efficiency and reliability, the M decoding methods are selected or set based on channel state information CSI of the M channels. In addition, the M decoding methods may be in one-to-one correspondence with and used in conjunction with the foregoing M encoding methods.

In another possible implementation, a correspondence between the K decoding methods and the M channels between the first protocol layer and the second protocol layer may not be one-to-one, where K is equal to M or K is a positive integer not equal to M. For example, the correspondence between the K decoding methods and the M channels includes one or more of a one-to-one relationship, a many-to-one relationship, and a one-to-many relationship.

In a possible implementation, the method further includes: The second apparatus sends first information or second information to the first apparatus based on a successfully decoded data packet, where the first information indicates that decoding succeeds, and the second information indicates that decoding fails.

In a possible implementation, that the second apparatus sends the first information or the second information to the first apparatus based on the successfully decoded data packet may include: sending the first information to the first apparatus when determining, based on the successfully decoded data packet, that a first condition is met, where the first condition may include but is not limited to one or more of the following:
(1) a ratio of a quantity of successfully decoded data packets to a quantity of received encoded data packets is not less than a first threshold;
(2) a quantity of unsuccessfully decoded data packets is within a quantity range indicated by the first error tolerance capability; and
(3) an application layer restores the first data based on the successfully decoded data packet.

In a possible implementation, that the second apparatus sends the first information or the second information to the first apparatus based on the successfully decoded data packet may include: sending the second information to the first apparatus when the second apparatus determines, based on the successfully decoded data packet, that a second condition is met, where the second condition may include but is not limited to one or more of the following:
(1) a ratio of a quantity of successfully decoded data packets to a quantity of received encoded data packets is less than a first threshold;
(2) a quantity of unsuccessfully decoded data packets is not within a quantity range indicated by the first error tolerance capability; and
(3) an application layer cannot restore the first data based on the successfully decoded data packet.

In a possible implementation, the second information may further indicate to retransmit an encoded data packet that is unsuccessfully decoded.

In this embodiment of this application, the second apparatus may feed back a result of one time of decoding to the first apparatus based on an overall decoding status of one piece of data (including one or more data packets).

For example, the first data is used as an example. After receiving the N data packets of the first data, the second apparatus sends the first information or the second information to the first apparatus. The first information indicates that the first data is successfully decoded, and the second information indicates that the first data is unsuccessfully decoded, or indicates the first apparatus to retransmit an unsuccessfully decoded data packet in the first data.

For example, after the second apparatus receives the N data packets of the first data, a quantity of successfully decoded data packets is k (k is an integer less than or equal to N). If a value of k/N is not less than a first threshold, or the quantity k of successfully decoded data packets is within a data packet quantity range indicated by the first error tolerance capability, or the application layer restores/generates the first data based on the k successfully decoded data packets, the second apparatus sends the first information to the first apparatus, where the first information indicates that the first data is successfully decoded.

For example, after the second apparatus receives the N data packets of the first data, a quantity of successfully decoded data packets is k (k is an integer less than N). If a value of k/N is less than a first threshold, or the quantity k of successfully decoded data packets is not within a data packet quantity range indicated by the first error tolerance capability, or the application layer cannot restore or generate the first data based on the k successfully decoded data packets, the second apparatus sends the second information to the first apparatus, where the second information indicates that the first data is unsuccessfully decoded, or indicates the first apparatus to retransmit the unsuccessfully decoded data packet in the first data.

The foregoing S501 to S503 are described by using the first data packet in the first data as an example. For data packets in other data, refer to the foregoing S501 to S503. Details are not described herein again. During actual application, channel encoding and transmission may be performed synchronously or asynchronously on one or more data packets with reference to the foregoing S501 to S503, and the plurality of data packets may belong to one piece of data, or may belong to different pieces of data.

In conclusion, embodiments of this application provide the communication method. The method includes: The first apparatus performs channel encoding processing on the first data packet based on the first context information, to obtain the encoded first data packet, where the first context information is associated with the first data having the first error tolerance capability, the first context information indicates the time association and/or spatial association between two frames, the first error tolerance capability indicates that the frame to which the first data belongs is supported to be obtained based on the preset quantity of data packets, the first data includes the N data packets, the first data packet is any one of the N data packets, and N is a positive integer; and the first apparatus sends the encoded first data packet to the second apparatus. According to the method, encoding efficiency can be effectively improved, and data transmission reliability and data transmission performance (or efficiency) can also be improved.

Based on the communication method described in the foregoing FIG. 5, the following describes in detail by using a specific embodiment.

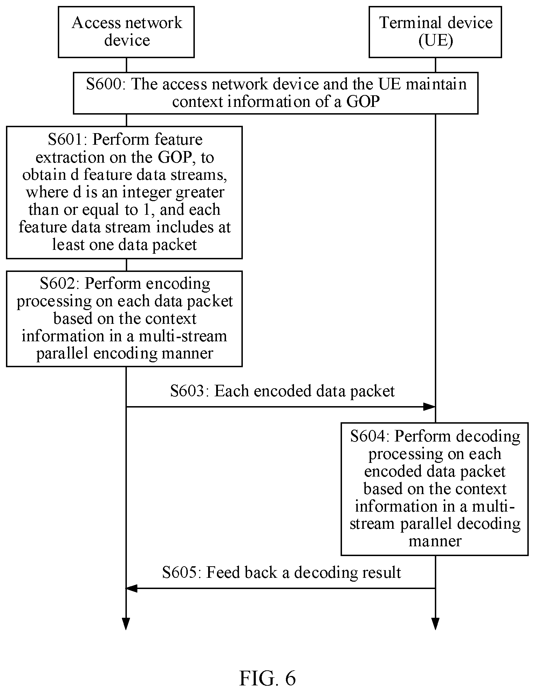

Embodiment 1: Based on the solution in the foregoing FIG. 5, a group of pictures GOP is used as an example of to-be-transmitted data. A first apparatus is an access network device (for example, a base station), a second apparatus is a terminal device (UE), and the access network device (a transmitting end) sends GOP data to the UE (a receiving end). As shown in FIG. 6, a procedure in this embodiment includes the following steps:
S600: The access network device and UE maintain context information of the GOP.

An access network device side maintains the context information associated with the group of pictures (group of pictures, GOP).

In a possible implementation, that the access network device (a transmitting end) obtains or establishes the context information of the GOP may include the following manners:
Manner 1: An application layer directly provides the context information of the GOP.
Manner 2: The access network device locally extracts GOP data based on an AI model, to obtain the context information.

In a possible implementation, that the UE (a receiving end) obtains the context information of the GOP may include the following manners:
Manner 1: The UE obtains the context information of the GOP from the access network device (that is, the access network device sends the context information of the GOP to the UE in advance).
Manner 2: The UE extracts initial GOP data by using a preset model (for example, an AI model), to obtain context information; and updates the context information based on a data packet of the current GOP, to obtain the context information of the GOP.

In this embodiment of this application, the access network device and the UE need to align context information in real time. For example, context information that is of the GOP and that is respectively maintained by the access network device and the UE is the same in real time.

For example, in a lossless handover scenario (the UE is handed over from a source base station to a target base station), it is usually required that transmitted data cannot be lost. Therefore, in this scenario, after sending GOP data stored in the source base station, if the source base station does not obtain feedback indicating that the UE successfully receives the data, the source base station forwards the GOP data and context information of the GOP data to the target base station, and subsequently sends the GOP data to the UE via the target base station. In this way, no data loss occurs on the UE.

S600 is an initial phase, and may be implemented offline. This is not limited herein.

S601: The access network device performs feature extraction on the GOP, to obtain d feature data streams, where d is an integer greater than or equal to 1, and each feature data stream includes at least one data packet.

In this embodiment of this application, as there may be d different target objects in a single frame of picture, these target objects may be extracted from the single frame of picture by using methods such as instance segmentation, to obtain d different pieces of feature data or d different feature data packets. Therefore, for a group of pictures (that is, a plurality of frames of pictures), d feature data streams may be obtained through extraction performed by using methods such as instance segmentation. The d feature data streams carry different semantic information or content, and the d feature data streams correspond to different error tolerance capabilities, where d is an integer greater than or equal to 1. When d is equal to 1, the GOP may be considered as a single feature data stream.

For example, target objects included in the group of pictures GOP are the sky and a building. As there is a small difference between details of the background sky, feature data extracted from the background sky has a good error tolerance capability. However, as details of the foreground building are different, feature data extracted from the building has a poor error tolerance capability.

In this embodiment of this application, for the d feature data streams, each feature data stream correspondingly includes/contains at least one data packet packet (or at least one IP packet). The packet (or the IP packet) of each feature data stream is marked as a data packet bundle (packet bundle), that is, packets (or IP packets) belonging to a same feature data stream are marked as a same bundle bundle. As the d feature data streams correspond to different context information and different error tolerance capabilities, the d feature data streams correspond to different packet bundles.

In a possible implementation, when sending each bundle of packets (or IP packets), the access network device may further attach relative weight information of these packets (or IP packets) in an associated manner. Relative weight information of each packet (or IP packet) indicates an error tolerance capability of a corresponding feature data stream, so that the receiving end can perform differentiated processing on different packets (or IP packets) based on the relative weight information.

For example, there are two feature data streams: a first feature data stream and a second feature data stream. A packet bundle corresponding to the first feature data stream is a bundle 1, and a packet bundle corresponding to the second feature data stream is a bundle 2. A packet 1 and a packet 2 of the first feature data stream are separately marked as the bundle 1, and a packet 3 and a packet 4 of the second feature data stream are separately marked as the bundle 2.

In a possible implementation, a transmission data packet corresponding to one feature data stream may include one or more IP packets, and each IP packet carries indication information (an example of the first indication information in the solution described in the foregoing FIG. 5), to indicate a packet bundle to which the IP packet belongs, and indicate an error tolerance capability corresponding to the packet bundle to which the IP packet belongs.

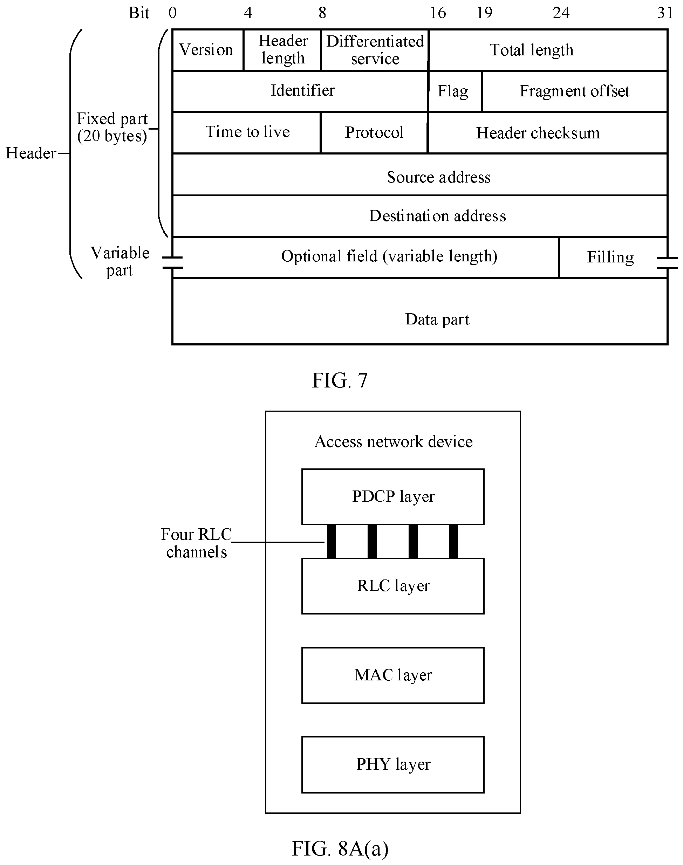

For example, refer to a structure of an IP packet header shown in FIG. 7. An indication field is added to the IP packet header (a header), to mark or indicate a packet bundle to which a current IP packet belongs, and indicate a corresponding error tolerance capability.

In a possible implementation, an 8-bit indication field is added to the IP packet header, where first four bits indicate an identifier (for example, an ID or an index) of a packet bundle to which the IP packet belongs, and last four bits indicate a corresponding error tolerance capability.

For example, a first feature data stream is used as an example. An ID or an index of a packet bundle of the first feature data stream is 5, and an acceptable quantity of incorrectly decoded IP packets in the first feature data stream is 3 (which is an example of an error tolerance capability of the first feature data stream). An IP packet of the first feature data stream is used as an example. An 8-bit indication field is added to an IP packet header. First four bits in the indication field are marked as 0101, and last four bits in the indication field are marked as 0011.

For example, a first feature data stream is used as an example. An ID or an index of a packet bundle of the first feature data stream is 5, and the first feature data stream supports obtaining the first feature data stream (which is an example of an error tolerance capability of the first feature data stream) based on nine correct IP packets. An IP packet of the first feature data stream is used as an example. An 8-bit indication field is added to an IP packet header. First four bits in the indication field are marked as 0101, and last four bits in the indication field are marked as 1001.

For example, error tolerance capabilities of d feature data streams are respectively represented by using indexes, and different indexes may represent/correspond to different error tolerance capabilities. In a possible implementation, the d feature data streams may respectively accept different quantities of incorrectly decoded IP packets (which are an example of the error tolerance capabilities of the d feature data streams). After the d feature data streams are sorted in descending order (or ascending order) based on acceptable quantities that are of incorrectly decoded IP packets and that respectively correspond to the d feature data streams, corresponding indexes are matched or set for the sorted d feature data streams.

For example, an acceptable quantity of incorrectly decoded IP packets in the first feature data stream is 3, an acceptable quantity of incorrectly decoded IP packets in a second feature data stream is 1, and an acceptable quantity of incorrectly decoded IP packets in a third feature data stream is 2. After three feature data streams are sorted in descending order based on values of the acceptable quantities that are of incorrectly decoded IP packets and that correspond to the three feature data streams, the three feature data streams are: the first feature data stream, the third feature data stream, and the second feature data stream. Therefore, an index corresponding to the first feature data stream is set to 1, an index corresponding to the third feature data stream is set to 2, and an index corresponding to the second feature data stream is set to 3.

Using the foregoing first feature data stream as an example, an ID or an index of a packet bundle of the first feature data stream is 5, an index corresponding to an error tolerance capability of the first feature data stream is 1, and the index 1 indicates that the acceptable quantity of incorrectly decoded IP packets in the first feature data stream is 3. An IP packet of the first feature data stream is used as an example. An 8-bit indication field is added to an IP packet header. First four bits in the indication field are marked as 0101, and last four bits in the indication field are marked as 0001.

S602: The access network device performs encoding processing on each data packet based on the context information in a multi-stream parallel encoding manner.

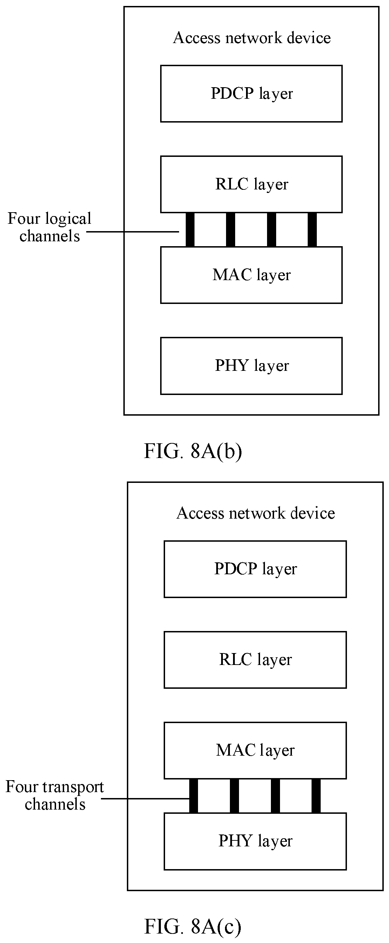

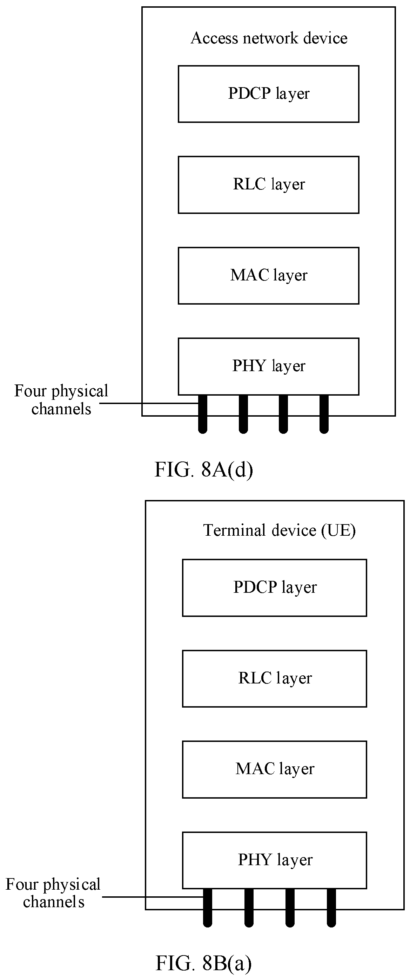

Downlink transmission is used as an example. Refer to protocol structures on an access network device side shown in FIG. 8A(a), FIG. 8A(b), FIG. 8A(c), and FIG. 8A(d). A plurality of streams (or a plurality of channels) that are set up may include but are not limited to the following several cases:
Case 1: There are a plurality of channels between a PDCP layer and an RLC layer.

For example, one PDCP entity is connected to four RLC entities below. That is, as shown in FIG. 8A(a), there are four RLC channels between the PDCP layer and the RLC layer.

Case 2: There are a plurality of channels between the RLC layer and a MAC layer.

For example, one RLC entity is connected to four MAC entities below. That is, as shown in FIG. 8A(b), there are four logical channels between the RLC layer and the MAC layer.

Case 3: There are a plurality of channels between the MAC layer and a PHY layer.

For example, one MAC entity is connected to four PHY entities below. That is, as shown in FIG. 8A(c), there are four transport channels between the MAC layer and the PHY layer.

Case 4: A plurality of physical channels are set up below the PHY layer. For example, with reference to FIG. 8A(d), four physical channels are set up.

In this embodiment of this application, a higher layer and a lower layer may be relative. For example, if the PDCP layer is the higher layer, any one of the RLC layer, the MAC layer, and the PHY layer may be considered as the lower layer; if the RLC layer is the higher layer, either of the MAC layer and the PHY layer may be considered as the lower layer; or if the MAC layer is the higher layer, the PHY layer may be considered as the lower layer. A bottom layer (for example, the RLC layer, the MAC layer, or the PHY layer) has a coding capability. In addition, the PDCP layer may also have a coding capability.

In a possible implementation, at a transmitting end, the higher layer first copies a to-be-sent data packet (or to-be-sent information), and then delivers the copied data packet (or information) to the bottom layer, and the bottom layer performs concurrent encoding processing on the copied data packet (or information).

In the following, a data packet 1 (that is, an example of the first data packet in the solution in the foregoing FIG. 5) in a first feature data stream (that is, an example of the first data in the solution in the foregoing FIG. 5) in d feature data streams is used as an example to describe in detail channel encoding in step S602.

For case 1, refer to FIG. 8A(a). Performing channel encoding on the access network device (the transmitting end) side may include but is not limited to the following manners:
Manner 1: The to-be-sent data packet 1 is copied at the SDAP layer into four same data packets 1, and then the four same data packets 1 are sent to the PDCP layer; or the data packet 1 is directly copied at the PDCP layer, to obtain four same data packets 1. Channel encoding is performed on the four same data packets 1 respectively (concurrently) at the PDCP layer based on context information of the first feature data stream by using four channel encoding manners, to obtain four encoded data packets 1. Then, the four encoded data packets 1 are sent to the RLC layer through four RLC channels, so that combination processing can be performed on the four encoded data packets 1 at the RLC layer.
Manner 2: The to-be-sent data packet 1 is copied at the PDCP layer, to obtain four same data packets 1, and then the four same data packets 1 are sent to the RLC layer through four RLC channels (the four same data packets 1 may be in one-to-one correspondence with the four RLC channels). Channel encoding is performed on the four same data packets 1 respectively (concurrently) at the RLC layer based on the context information of the first feature data stream by using four channel encoding manners, to obtain four encoded data packets 1. Then, combination processing can be performed on the four encoded data packets 1 at the RLC layer, or combination processing can be performed on the four encoded data packets 1 at the MAC layer or the PHY layer.

In the foregoing, the four channel encoding manners are different, and are in one-to-one correspondence with and match the four RLC channels between the PDCP layer and the RLC layer.

For case 2, refer to FIG. 8A(b). Performing channel encoding on the access network device (the transmitting end) side may include but is not limited to the following manners:
Manner 1: The to-be-sent data packet 1 is copied at the PDCP layer, to obtain four same data packets 1, and then the four same data packets 1 are sent to the RLC layer; or the data packet 1 is directly copied at the RLC layer, to obtain four same data packets 1. Channel encoding is performed on the four same data packets 1 respectively (concurrently) at the RLC layer based on the context information of the first feature data stream by using four channel encoding manners, to obtain four encoded data packets 1. Then, the four encoded data packets 1 are sent to the MAC layer through four logical channels, so that combination processing can be performed on the four encoded data packets 1 at the MAC layer.
Manner 2: The to-be-sent data packet 1 is copied at the RLC layer, to obtain four same data packets 1, and then the four same data packets 1 are sent to the MAC layer through four logical channels (the four same data packets may be in one-to-one correspondence with the four logical channels). Channel encoding is performed on the four same data packets respectively (concurrently) at the MAC layer based on the context information of the first feature data stream by using four channel encoding manners, to obtain four encoded data packets 1. Then, combination processing can be performed on the four encoded data packets 1 at the MAC layer, or combination processing can be performed on the four encoded data packets 1 at the PHY layer.

In the foregoing, the four channel encoding manners are different, and are in one-to-one correspondence with and match the four logical channels between the RLC layer and the MAC layer.

For case 3, refer to FIG. 8A(c). Performing channel encoding on the access network device (the transmitting end) side may include but is not limited to the following manners:
Manner 1: The to-be-sent data packet 1 is copied at the RLC layer, to obtain four same data packets 1, and then the four same data packets 1 are sent to the MAC layer; or the data packet 1 is copied at the MAC layer, to obtain four same data packets 1. Channel encoding is performed on four same first data packets respectively (concurrently) at the MAC layer based on the context information of the first feature data stream by using four channel encoding manners, to obtain four encoded data packets 1. Then, the four encoded data packets 1 are sent to the PHY layer through four transport channels, so that combination processing can be performed on the four encoded data packets 1 at the PHY layer.
Manner 2: The to-be-sent data packet 1 is copied at the MAC layer, to obtain four same data packets 1, and then the four same data packets 1 are sent to the PHY layer through four transport channels (the four same data packets may be in one-to-one correspondence with the four transport channels). Channel encoding is performed on the four same data packets respectively (concurrently) at the PHY layer based on the context information of the first feature data stream by using four channel encoding manners, to obtain four encoded data packets 1. Then, combination processing can be performed on the four encoded data packets 1 at the PHY layer.

In the foregoing, the four channel encoding manners are different, and are in one-to-one correspondence with and match the four transport channels between the MAC layer and the PHY layer.

For case 4, refer to FIG. 8A(d). Performing channel encoding on the access network device (the transmitting end) side may include but is not limited to the following:

The to-be-sent data packet 1 may be copied at the MAC layer, to obtain four same data packets 1, and then the four same data packets 1 are sent to the PHY layer; or the data packet 1 is copied at the PHY layer, to obtain four same data packets 1. Then, channel encoding is performed on the four same data packets 1 respectively (concurrently) at the PHY layer based on context information of first feature data by using four channel encoding manners, to obtain four encoded data packets 1. Then, the four encoded data packets 1 are sent (to UE) through four physical channels. The four channel encoding manners are different, and are in one-to-one correspondence with and match the four physical channels.

In the foregoing, the four channel encoding manners are different, and are in one-to-one correspondence with and match the four physical channels.

For channel encoding processing performed by the access network device (the transmitting end) on another data packet in the first feature data stream and a data packet in another feature data stream in the d feature data streams, refer to the foregoing implementation in which the access network device performs channel encoding on the data packet 1. Details are not described herein again.

S603: The access network device sends each encoded data packet to the UE. Correspondingly, the UE receives each encoded data packet.

In the foregoing SS602, the access network device completes channel encoding processing on all data packets in the d feature data streams, and then in S603, the access network device sends all encoded data packets to the UE. In this embodiment of this application, to consider a delay requirement of data transmission (or reduce a delay of data transmission), the access network device (the transmitting end) may use a plurality of transport blocks (multi-TB) for scheduling. For example, the plurality of transport blocks TBs may be scheduled by using one piece of downlink control information DCI, the transport blocks are used as a transport block bundle (TB bundle), and a size (bundle size) is variable. Each TB may carry one or more packets.

In a possible implementation, one TB bundle may correspond to one packet bundle. That is, TBs in one TB bundle are used to transmit data packets of a same feature data stream. However, a correspondence between a TB and a data packet packet is not specifically limited in this application.

For example, d = 2, that is, there are two feature data streams: a first feature data stream and a second feature data stream. The first feature data stream includes N1 packets (N1 is an integer greater than or equal to 1), and N1 encoded packets are obtained through the channel encoding processing in the foregoing S602. The second feature data stream includes N2 packets (N2 is an integer greater than or equal to 1), and N2 encoded packets are obtained through the channel encoding processing in the foregoing S602.

For the N1 encoded packets of the first feature data stream, the access network device schedules one TB bundle including T1 transport blocks (TB), where T1 is a positive integer; and then transmits the N1 encoded packets by using the T1 transport blocks (each transport block carries one or more encoded packets). Similarly, for the N2 encoded packets of the second feature data stream, the access network device schedules another TB bundle including T2 transport blocks (TB), where T2 is a positive integer; and then transmits the N2 encoded packets by using the T2 transport blocks (each transport block carries one or more encoded packets).

S604: The UE performs decoding processing on each encoded data packet based on the context information in a multi-stream parallel decoding manner.

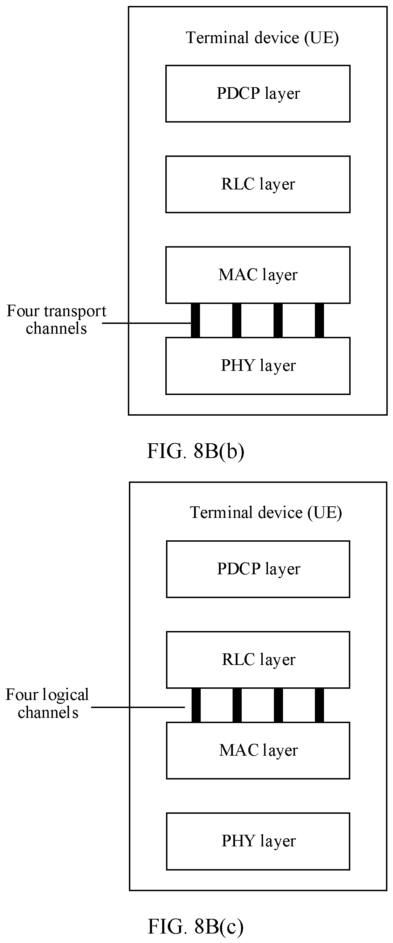

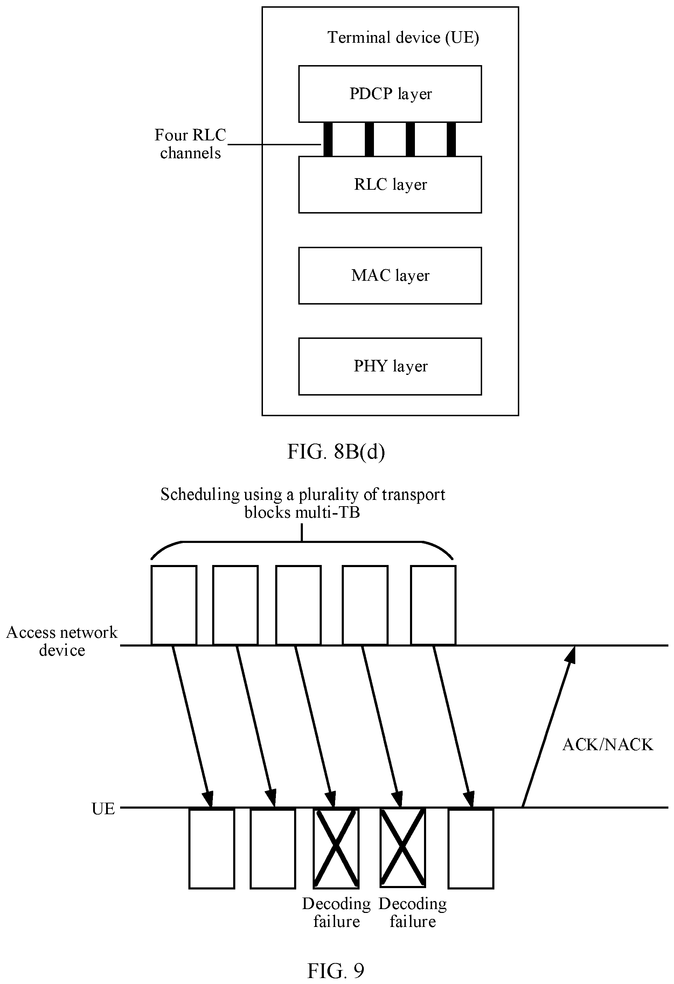

Refer to protocol structures on a terminal device UE side shown in FIG. 8B(a), FIG. 8B(b), FIG. 8B(c), and FIG. 8B(d). A plurality of streams (or a plurality of channels) that are set up may include but are not limited to the following several cases:
Case 1: A plurality of physical channels are set up below a PHY layer.

For example, as shown in FIG. 8B(a), four physical channels are set up below a PHY entity.

Case 2: There are a plurality of channels between the PHY layer and a MAC layer.

For example, one PHY entity is connected to four MAC entities above. That is, as shown in FIG. 8B(b), there are four transport channels between the PHY layer and the MAC layer.

Case 3: There are a plurality of channels between the MAC layer and an RLC layer.

For example, one MAC entity is connected to four RLC entities above. That is, as shown in FIG. 8B(c), there are four logical channels between the MAC layer and the RLC layer.

Case 4: There are a plurality of channels between the RLC layer and a PDCP layer.

For example, one RLC entity is connected to four PDCP entities above. That is, as shown in FIG. 8B(d), there are four RLC channels between the RLC layer and the PDCP layer.

In this embodiment of this application, a higher layer and a lower layer may be relative. For example, if the PDCP layer is the higher layer, any one of the RLC layer, the MAC layer, and the PHY layer may be considered as the lower layer; if the RLC layer is the higher layer, either of the MAC layer and the PHY layer may be considered as the lower layer; or if the MAC layer is the higher layer, the PHY layer may be considered as the lower layer.

In a possible implementation, after receiving the encoded data packet, a bottom layer (for example, the PHY layer) may copy encoded data/information, and then deliver the copied data/information to the higher layer, and the higher layer performs concurrent decoding processing.

For example, one transport block TB is used as an example. The TB carries K encoded data packets (K is an integer greater than or equal to 1). After receiving the TB, the PHY layer of the UE may make four copies of each encoded data packet in the TB, and then perform subsequent multi-stream parallel decoding.

In S602, the data packet 1 (that is, the example of the first data packet in the solution in the foregoing FIG. 5) in the first feature data stream (that is, the example of the first data in the solution in the foregoing FIG. 5) in the d feature data streams is used as an example to perform channel encoding processing, to obtain the encoded data packet 1. In the following, the encoded data packet 1 (that is, an example of the encoded first data packet in the solution in the foregoing FIG. 5) is used as an example to describe in detail channel encoding/decoding in step S604.

For case 1, refer to FIG. 8B(a). Performing channel decoding on the UE (a receiving end) side may include but is not limited to the following manners:

At the PHY layer, the received encoded data packet 1 is copied, to obtain four same encoded data packets 1, and then channel decoding processing is performed on the four encoded data packets 1 based on context information of the first feature data stream by using four decoding manners (one decoding method corresponds to decoding one encoded data packet 1), to obtain four data packets 1. Combination processing is performed on the four data packets 1 at the PHY layer, to obtain a complete data packet 1; or the four data packets are sent from the PHY layer to the MAC layer, or the RLC layer, or the PDCP layer, to perform combination processing.

In the foregoing, the four channel decoding manners are different, and are in one-to-one correspondence with and match the four physical channels.

For case 2, refer to FIG. 8B(b). Performing channel decoding on the UE (the receiving end) side may include but is not limited to the following manners:
Manner 1: At the PHY layer, the received encoded data packet 1 is copied, to obtain four same encoded data packets 1, and then channel decoding processing is performed on the four encoded data packets 1 based on the context information of the first feature data stream by using four decoding manners (one decoding manner may correspond to decoding one encoded data packet 1), to obtain four data packets 1. Then, the four data packets 1 are sent to the MAC layer through four transport channels (the four data packets may be in one-to-one correspondence with the four transport channels). Combination processing is performed on the four data packets 1 at the MAC layer, to obtain a complete data packet 1.
Manner 2: At the PHY layer, the received encoded data packet 1 is copied, to obtain four same encoded data packets 1, and then the four same encoded data packets 1 are sent to the MAC layer through four transport channels. Channel decoding processing is performed on the four encoded data packets 1 respectively (concurrently) at the MAC layer based on the context information of the first feature data stream by using four decoding manners (one decoding manner may correspond to decoding one encoded data packet 1), to obtain four data packets 1. Then, combination processing is performed on the four data packets 1 at the MAC layer, to obtain a complete data packet 1; or the four data packets are sent from the MAC layer to the RLC layer or the PDCP layer to perform combination processing.

In the foregoing, the four channel decoding manners are different, and are in one-to-one correspondence with and match the four transport channels between the MAC layer and the PHY layer.

For case 3, refer to FIG. 8B(c). Performing channel decoding on the UE (the receiving end) side may include but is not limited to the following manners:
Manner 1: At the PHY layer, the received encoded data packet 1 is copied, to obtain four same encoded data packets 1, and then the four same encoded data packets 1 are sent to the MAC layer; or the MAC layer copies the received encoded data packet 1, to obtain four same encoded data packets 1. Channel decoding processing is performed on the four encoded data packets 1 respectively (concurrently) at the MAC layer based on the context information of the first feature data stream by using four decoding manners (one decoding manner may correspond to decoding one encoded data packet 1), to obtain four data packets 1. Then, the four data packets 1 are sent to the RLC layer through four logical channels, and combination processing is performed on the four data packets 1 at the RLC layer.
Manner 2: The four same encoded data packets 1 obtained through copying are sent from the MAC layer to the RLC layer through four logical channels. Channel decoding processing is performed on the four encoded data packets 1 respectively (concurrently) at the RLC layer based on the context information of the first feature data stream by using four decoding manners (one decoding manner may correspond to decoding one encoded data packet 1), to obtain four data packets 1. Then, combination processing is performed on the four data packets at the RLC layer; or the four data packets are reported to the PDCP layer to perform combination processing.

In the foregoing, the four channel decoding manners are different, and are in one-to-one correspondence with and match the four logical channels between the RLC layer and the MAC layer.

For case 4, refer to FIG. 8B(d). Performing channel decoding on the UE (the receiving end) side may include but is not limited to the following manners:
Manner 1: The four same encoded data packets 1 obtained through copying are received at the RLC layer. Channel decoding processing is performed on the four encoded data packets 1 respectively (concurrently) based on the context information of the first feature data stream by using four decoding manners (one decoding manner may correspond to decoding one encoded data packet 1), to obtain four data packets 1. Then, the four data packets 1 are sent to the PDCP layer through four RLC channels, and combination processing is performed on the four data packets 1 at the PDCP layer.
Manner 2: The four same encoded data packets 1 obtained through copying are sent from the RLC layer to the PDCP layer through four RLC channels. Channel decoding processing is performed on the four encoded data packets 1 respectively (concurrently) at the PDCP layer based on the context information of the first feature data stream by using four decoding manners (one decoding manner may correspond to decoding one encoded data packet 1), to obtain four data packets 1. Then, combination processing is performed on the four data packets 1.

In the foregoing, the four channel decoding manners are different, and are in one-to-one correspondence with and match the four RLC channels between the PDCP layer and the RLC layer.

For channel decoding processing performed by the terminal device UE (the receiving end) on another data packet in the first feature data stream and a data packet in another feature data stream in the d feature data streams, refer to the foregoing implementation in which the UE performs channel decoding on the encoded data packet 1. Details are not described herein again.

S605: The UE feeds back a decoding result to the access network device.

In a possible implementation, the UE decides to send an acknowledgment (acknowledgment, ACK) message or a negative acknowledgment (negative acknowledgment, NACK) message to the access network device only after receiving a complete TB bundle.

Therefore, when the UE receives one TB in the TB bundle, if the TB is not correctly decoded, it indicates that one or more corresponding packets (IP data packets) are incorrectly sent. In this case, the PHY layer of the UE does not need to immediately feed back the NACK message to the access network device to request retransmission of the corresponding packet (or IP data packet), but performs decision and feedback after successfully receiving all TBs in the TB bundle.

For example, refer to FIG. 9. One TB bundle sent by an access network device to UE includes five TBs. After receiving the five TBs, the UE decides to send an ACK or a NACK to the access network device.

For example, for a first feature data stream (any feature data stream) in d feature data streams, a packet of the first feature data stream corresponds to one packet bundle, and the packet bundle corresponds to one TB bundle (one TB bundle corresponds to a plurality of TBs). For the received TB bundle, the UE may decide to feed back the ACK or the NACK to the access network device in but not limited to the following manners:
Manner 1: For the TB bundle, the UE determines a ratio of a quantity of correctly decoded TBs to a total quantity of TBs in the TB bundle. If the ratio is not less than a specified threshold, the UE feeds back the ACK to the access network device; or if the ratio is less than a specified threshold, the UE feeds back the NACK to the access network device.
Manner 2: For the TB bundle, the UE determines a ratio of a quantity of correctly decoded packets to a total quantity of packets carried in the TB bundle. If the ratio is not less than a specified threshold, the UE feeds back the ACK to the access network device; or if the ratio is less than a specified threshold, the UE feeds back the NACK to the access network device.
Manner 3: For the TB bundle, if the UE determines that a quantity of correctly decoded packets is within an error tolerance capability range corresponding to the feature data stream, the UE feeds back the ACK to the access network device; or if the UE determines that a quantity of correctly decoded packets is not within an error tolerance capability range corresponding to the feature data stream, the UE feeds back the NACK to the access network device.

For example, the UE parses a packet header of any packet in the packet bundle corresponding to the first feature data stream, to determine that last four bits of a newly added 8-bit indication field are marked as 1001, indicating that the feature data stream supports obtaining the feature data stream based on nine correct IP packets. Therefore, for the packet of the first feature data stream, if the UE determines that a quantity of successfully decoded packets is at least 9, the UE feeds back the ACK to the access network device; or if the UE determines that a quantity of successfully decoded packets is less than 9, the UE feeds back the NACK to the access network device.

Manner 4: For the TB bundle, if the UE can successfully restore a frame of picture of the feature data stream based on correctly decoded packets, the UE feeds back the ACK to the access network device; or if the UE cannot successfully restore a frame of picture corresponding to the feature data stream based on correctly decoded packets, the UE feeds back the NACK to the access network device.

In another possible implementation, the UE further receives second indication information from the access network device, where the second indication information indicates that the UE may feed back the ACK message to the access network device in advance when a quantity of correct TBs received from the access network device reaches a preset quantity, and notifies the access network device not to send a remaining TB. That the quantity of correct TBs reaches the preset quantity means that the UE can successfully restore a corresponding frame of picture based on the preset quantity of correct TBs.

For example, for a TB bundle, if the TB bundle includes five TBs, the access network device indicates that the UE may feed back the ACK message to the access network device when three correct TBs are received. During transmission, the access network device sends TBs of the TB bundle to the UE. After receiving three correct TBs or when receiving three correct TBs, the UE sends the ACK message to the access network device. After receiving the ACK message, the access network device does not continue to send the remaining two TBs to the UE.

In this embodiment of this application, the foregoing TB may be correspondingly replaced with a service data unit SDU, a packet, or the like at another layer (for example, the MAC layer, the RLC layer, or the PDCP layer shown in FIG. 3B).

For example, for any feature data stream, if the feature data stream corresponds to N encoded packets (N is an integer greater than 1), after receiving all the encoded packets corresponding to the feature data stream (or after performing channel decoding on all the encoded packets corresponding to the feature data stream), the UE decides to send the ACK message or the NACK message to the access network device. Alternatively, after correctly receiving a preset quantity of encoded packets (or a quantity of correctly decoded packets reaches a preset quantity), the UE sends the ACK message to the access network device, and notifies the access network device not to send a remaining encoded packet corresponding to the feature data stream.

In this embodiment, an example in which a first apparatus (a transmitting end) is the access network device, and a second apparatus (a receiving end) is terminal device UE is used. To-be-transmitted data is a GOP, and the access network device and the UE both maintain (obtain) context information of the to-be-transmitted GOP data. When serving as a transmitting end of the GOP data, the access network device first performs feature extraction on the GOP data, to obtain at least one feature data stream. Then, the access network device performs channel encoding processing respectively (concurrently) on each corresponding data packet based on context information of each feature data stream, and sends the data packet to the UE. This can improve encoding efficiency of the transmitting end, and also can improve data transmission reliability and performance (for example, a transmission rate). On a UE side, the UE performs channel decoding processing respectively (concurrently) on each corresponding encoded data packet based on the context information of each feature data stream. This can effectively improve decoding accuracy (or a decoding capability) and decoding efficiency of the receiving end. In addition, to consider a delay requirement of data transmission (or reduce a delay of data transmission), in this embodiment of this application, a plurality of transport blocks (multi-TB) may be used for scheduling. To be specific, a data packet (or an IP packet) of each feature data stream is transmitted by using a transport block of one TB bundle, and a receiving end side may perform decoding decision and feedback by transport block of the TB bundle.

In the foregoing embodiments provided in this application, the method provided in embodiments of this application is separately described from a perspective of interaction between the devices. To implement functions in the foregoing methods provided in embodiments or implementations of this application, the first apparatus or the second apparatus may include a hardware structure and/or a software module, to implement the foregoing functions in a form of the hardware structure, the software module, or a combination of the hardware structure and the software module. Whether a function in the foregoing functions is performed by using the hardware structure, the software module, or the combination of the hardware structure and the software module depends on particular applications and design constraints of the technical solutions.

In embodiments of this application, module division is an example, and is merely logical function division. During an actual implementation, there may be another division manner. In addition, functional modules in embodiments or implementations of this application may be integrated into one processor, or may exist alone physically, or two or more modules may be integrated into one module. The foregoing integrated module may be implemented in a form of hardware, or may be implemented in a form of a software functional module.

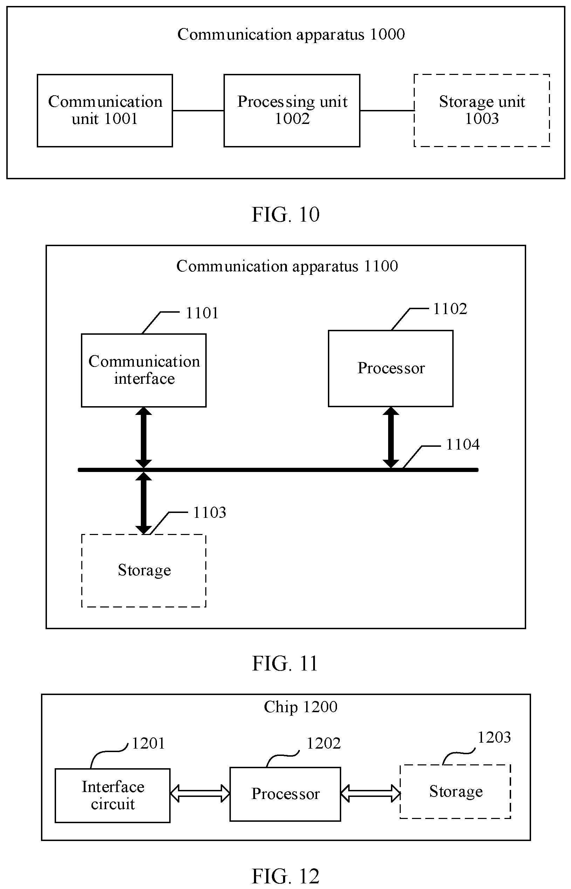

Same as the foregoing idea, as shown in FIG. 10, an embodiment of this application further provides a communication apparatus 1000, configured to implement functions of the first apparatus or the second apparatus in the foregoing methods. For example, the communication apparatus 1000 may be a software module or a chip system. In embodiments of this application, the chip system may include a chip, or may include a chip and another discrete component. The communication apparatus 1000 may include a communication unit 1001 and a processing unit 1002.

In this embodiment of this application, the communication unit 1001 may also be referred to as a transceiver unit, and may include a sending unit and/or a receiving unit, which are respectively configured to perform sending and receiving steps performed by the first apparatus or the second apparatus in the foregoing method embodiments. The processing unit 1002 may be configured to read instructions and/or data in a storage module, to enable the communication apparatus 1000 to implement the foregoing method embodiments.

Optionally, the communication apparatus 1000 may further include a storage unit 1003. The storage unit 1003 is equivalent to the storage module, and may be configured to store the instructions and/or the data.

The following describes in detail communication apparatuses provided in embodiments of this application with reference to FIG. 10 and FIG. 11. It should be understood that descriptions of apparatus embodiments correspond to the descriptions of method embodiments. Therefore, for content that is not described in detail, refer to the manners shown in the foregoing FIG. 5 and FIG. 6 for implementation. For brevity, details are not described herein again.

The communication unit 1001 may also be referred to as a transceiver, a transceiver machine, a transceiver apparatus, or the like. The processing unit may also be referred to as a processor, a processing board, a processing module, a processing apparatus, or the like. Optionally, a component that is in the communication unit 1001 and that is configured to implement a receiving function may be considered as a receiving unit, and a component that is in the communication unit 1001 and that is configured to implement a sending function may be considered as a sending unit. That is, the communication unit 1001 includes the receiving unit and the sending unit. The communication unit sometimes may also be referred to as a transceiver machine, a transceiver, a transceiver circuit, or the like. The receiving unit sometimes may also be referred to as a receiver machine, a receiver, a receiver circuit, or the like. The sending unit sometimes may also be referred to as a transmitter machine, a transmitter, a transmit circuit, or the like.

When the communication apparatus 1000 performs the procedure of the first apparatus shown in FIG. 5 in the foregoing embodiment, the processing unit 1002 is configured to perform channel encoding processing on a first data packet based on first context information, to obtain an encoded first data packet. The first context information is associated with first data having a first error tolerance capability, the first context information indicates time association and/or spatial association between two frames, the first error tolerance capability indicates that a frame to which the first data belongs is supported to be obtained based on a preset quantity of data packets, the first data includes N data packets, the first data packet is any one of the N data packets, and N is a positive integer; and the communication unit 1001 is configured to send the encoded first data packet.

When the communication apparatus 1000 performs the procedure of the second apparatus shown in FIG. 5 in the foregoing embodiment, the communication unit 1001 is configured to receive an encoded first data packet; and the processing unit 1002 is configured to perform channel decoding processing on the encoded first data packet based on first context information, to obtain a first data packet. The first context information is associated with first data having a first error tolerance capability, the first context information indicates time association and/or spatial association between two frames, the first error tolerance capability indicates that a frame to which the first data belongs is supported to be obtained based on a preset quantity of data packets, the first data includes N data packets, the first data packet is any one of the N data packets, and N is a positive integer.

The foregoing is merely an example. The communication unit 1001 and the processing unit 1002 may further perform other functions. For more detailed descriptions, refer to related descriptions in the method embodiments shown in FIG. 5 and FIG. 6. Details are not described herein again.

FIG. 11 shows a communication apparatus 1100 according to an embodiment of this application. The communication apparatus shown in FIG. 11 may be an implementation of a hardware circuit of the communication apparatus shown in FIG. 10. The communication apparatus 1100 is applicable to the flowchart shown above, and performs a function of the first apparatus or the second apparatus in the foregoing method embodiments. For ease of description, FIG. 11 shows only main parts of the communication apparatus.

As shown in FIG. 11, the communication apparatus 1100 includes a communication interface 1101 and a processor 1102. The communication interface 1101 and the processor 1102 are coupled to each other. It may be understood that the communication interface 1101 may be a transceiver or an input/output interface, or may be an interface circuit like a transceiver circuit. Optionally, the communication apparatus 1100 may further include a storage 1103 configured to store instructions executed by the processor 1102, or store input data required by the processor 1102 to run instructions, or store data generated after the processor 1102 runs instructions.

When the communication apparatus 1100 is configured to implement the methods shown in FIG. 5 and FIG. 6, the communication interface 1101 is configured to implement a function of the foregoing communication unit 1001, and the processor 1102 is configured to implement a function of the foregoing processing unit 1002.

This embodiment of this application does not limit a specific connection medium between the communication interface 1101, the processor 1102, and the storage 1103. In this embodiment of this application, the storage 1103, the processor 1102, and the communication interface 1101 are connected to each other through a communication bus 1104 in FIG. 11. The communication bus 1104 is represented by a bold line in FIG. 11. A connection manner between other components is merely an example for description, and is not limited thereto. The communication bus 1104 may be classified into an address bus, a data bus, a control bus, and the like. For ease of representation, only one bold line is used to represent the bus in FIG. 11, but this does not mean that there is only one bus or only one type of bus.

When the communication apparatus is a chip, FIG. 12 is a diagram of a simplified apparatus structure of the chip. The chip 1200 includes an interface circuit 1201 and one or more processors 1202. Optionally, the chip 1200 may further include a bus. Specifically:
The processor 1202 may be an integrated circuit chip and has a signal processing capability. In an implementation process, steps in the foregoing method for determining information about a service node may be implemented by using a hardware integrated logic circuit in the processor 1202, or by using instructions in a form of software. The foregoing processor 1202 may be a general-purpose processor, a digital signal processor (digital signal processor, DSP), an application-specific integrated circuit (application-specific integrated circuit, ASIC), a field-programmable gate array (field-programmable gate array, FPGA) or another programmable logic device, a discrete gate or transistor logic device, or a discrete hardware component. The methods and steps that are disclosed in embodiments of this application may be implemented or performed. The general-purpose processor may be a microprocessor, or the processor may be any conventional processor or the like.

The interface circuit 1201 may be configured to send or receive data, instructions, or information. The processor 1202 may perform processing by using the data, the instructions, or other information received through the interface circuit 1201, and may send processed information through the interface circuit 1201.

Optionally, the chip further includes a storage 1203. The storage 1203 may include a read-only memory and a random access memory, and provide operation instructions and data for the processor. A part of the storage 1203 may further include a non-volatile random access memory (non-volatile random access memory, NVRAM).

Optionally, the storage stores an executable software module or a data structure, and the processor may perform a corresponding operation by invoking operation instructions (the operation instructions may be stored in an operating system) stored in the storage.

Optionally, the chip may be used in the first apparatus or the second apparatus in embodiments of this application. Optionally, the interface circuit 1201 may be configured to output an execution result of the processor 1202. For the communication methods provided in one or more embodiments of this application, refer to the foregoing embodiments. Details are not described herein again.

It should be noted that functions respectively corresponding to the interface circuit 1201 and the processor 1202 may be implemented by using a hardware design, may be implemented by using a software design, or may be implemented by using a combination of software and hardware. This is not limited herein.

An embodiment of this application further provides a computer-readable storage medium. The computer-readable storage medium stores computer instructions for implementing the method performed by the first apparatus or the second apparatus in the foregoing method embodiments.

For example, when a computer program is executed by a computer, the computer is enabled to implement the method performed by the first apparatus or the second apparatus in the foregoing method embodiments.

An embodiment of this application further provides a computer program product including instructions. When the instructions are executed by a computer, the computer is enabled to implement the method performed by the first apparatus or the second apparatus in the foregoing method embodiments.

An embodiment of this application further provides a chip. The chip includes a processor that is configured to invoke a computer program or computer instructions stored in a storage, to cause the processor to perform the communication method in the implementations shown in the foregoing FIG. 5 and FIG. 6.

In a possible implementation, input of the chip corresponds to a receiving operation in the implementations shown in the foregoing FIG. 5 and FIG. 6, and output of the chip corresponds to a sending operation in the implementations shown in the foregoing FIG. 5 and FIG. 6.

Optionally, the processor is coupled to the storage through an interface.

Optionally, the chip further includes the storage. The storage stores the computer program or the computer instructions.

The processor mentioned anywhere above may be a general-purpose central processing unit, a microprocessor, an application-specific integrated circuit (application-specific integrated circuit, ASIC), or one or more integrated circuits configured to control program execution of communication methods in the implementations shown in FIG. 5 and FIG. 6. The storage mentioned anywhere above may be a read-only memory (read-only memory, ROM), another type of static storage device that can store static information and instructions, a random access memory (random access memory, RAM), or the like.

It should be noted that for ease and brevity of description, for explanations and beneficial effects of related content of any one of the communication apparatuses provided above, refer to the corresponding communication method embodiments provided above. Details are not described herein again.

In this application, a hardware layer, an operating system layer running above the hardware layer, and an application layer running above the operating system layer may be further included between communication apparatuses. The hardware layer may include hardware such as a central processing unit (central processing unit, CPU), a memory management unit (memory management unit, MMU), and a memory (also referred to as a main memory). An operating system at the operating system layer may be any one or more types of computer operating systems that implement service processing through a process (process), for example, a Linux operating system, a Unix operating system, an Android operating system, an iOS operating system, or a Windows operating system. The application layer may include applications such as a browser, an address book, word processing software, and instant messaging software.

Division into the modules in embodiments of this application is an example, is merely division into logical functions, and may be other division during actual implementation. In addition, functional modules in embodiments of this application may be integrated into one processor, or each of the modules may exist alone physically, or two or more modules may be integrated into one module. The foregoing integrated module may be implemented in a form of hardware, or may be implemented in a form of a software functional module.

Through descriptions of the foregoing implementations, a person skilled in the art may clearly understand that embodiments of this application may be implemented by hardware, firmware or a combination thereof. When this application is implemented by software, the foregoing functions may be stored in a computer-readable medium or transmitted as one or more instructions or code in the computer-readable medium. The computer-readable medium includes a computer storage medium and a communication medium, where the communication medium includes any medium that enables a computer program to be transmitted from one place to another place. The storage medium may be any available medium accessible to a computer. Examples of the computer-readable medium include but are not limited to: a RAM, a ROM, an electrically erasable programmable read only memory (electrically erasable programmable read only memory, EEPROM), a compact disc read-only memory (compact disc read-only memory, CD-ROM) or another optical disc storage, a disk storage medium or another disk storage device, or any other medium that can be used to carry or store expected program code in an instruction or data structure form and that can be accessed by a computer. In addition, any connection may be properly considered as the computer-readable medium. For example, if software is transmitted from a website, a server, or another remote source by using a coaxial cable, an optical fiber and optical cable, a twisted pair, a digital subscriber line (digital subscriber line, DSL), or wireless technologies such as infrared, radio, and microwave, the coaxial cable, the optical fiber and optical cable, the twisted pair, the DSL, or the wireless technologies such as infrared, radio, and microwave are included in a definition of a medium to which the coaxial cable, the optical fiber and optical cable, the twisted pair, the DSL, or the wireless technologies such as the infrared ray, the radio, and the microwave belong. For example, a disk (disk) and a disc (disc) used in embodiments of this application include a compact disc (compact disc, CD), a laser disc, an optical disc, a digital video disc (digital video disc, DVD), a floppy disk and a Blu-ray disc. The disk usually copies data by a magnetic means, and the disc copies data optically by a laser means. The foregoing combination should also be included within the protection scope of the computer-readable medium.

In conclusion, the foregoing descriptions are merely embodiments of this application and are not intended to limit the protection scope of this application. Any modification, equivalent substitution, and improvement made based on the disclosure of this application shall fall within the protection scope of this application.

## Claims

1. A communication method, wherein the method is applied to a first apparatus, and the method comprises:
performing channel encoding processing on a first data packet based on first context information, to obtain an encoded first data packet, wherein the first context information is associated with first data having a first error tolerance capability, the first context information indicates time association and/or spatial association between two frames, the first error tolerance capability indicates that a frame to which the first data belongs is supported to be obtained based on a preset quantity of data packets, the first data comprises N data packets, the first data packet is any one of the N data packets, and N is a positive integer; and
sending the encoded first data packet.

2. The method according to claim 1, wherein the performing channel encoding processing on the first data packet of the N data packets based on the first context information, to obtain the encoded first data packet comprises:
respectively performing channel encoding processing on M first data packets based on the first context information by using M encoding methods, to obtain M encoded data packets, wherein the M first data packets are obtained by copying the first data packet, the M encoding methods are in one-to-one correspondence with the M first data packets, and M is an integer greater than 1; and
obtaining the encoded first data packet based on the M encoded data packets.

3. The method according to claim 2, wherein the first apparatus comprises a first protocol layer and a second protocol layer;
the respectively performing channel encoding processing on the M first data packets based on the first context information by using the M encoding methods, to obtain the M encoded data packets comprises: respectively performing, at the first protocol layer or the second protocol layer, channel encoding processing on the M first data packets based on the first context information by using the M encoding methods, to obtain the M encoded data packets; and
the obtaining the encoded first data packet based on the M encoded data packets comprises: obtaining, at the second protocol layer, the encoded first data packet based on the M encoded data packets.

4. The method according to claim 2 or 3, wherein the respectively performing channel encoding processing on the M first data packets based on the first context information by using the M encoding methods, to obtain the M encoded data packets comprises:
obtaining channel state information CSI; and
respectively performing channel encoding processing on the M first data packets based on the first context information and the channel state information CSI by using the M encoding methods, to obtain the M encoded data packets.

5. The method according to claim 3, wherein the M encoding methods are in one-to-one correspondence with M channels between the first protocol layer and the second protocol layer.

6. The method according to claim 3 or 5, wherein the first protocol layer comprises any one of the following:
a packet data convergence protocol PDCP layer, a radio link control RLC layer, a media access control MAC layer, and a physical PHY layer; and
the second protocol layer comprises any one of the following:
a packet data convergence protocol PDCP layer, a radio link control RLC layer, a media access control MAC layer, and a physical PHY layer.

7. The method according to any one of claims 1 to 6, wherein the encoded first data packet carries first indication information, and the first indication information indicates that the encoded first data packet is associated with the first data.

8. The method according to claim 7, wherein the first indication information further indicates the first error tolerance capability.

9. The method according to any one of claims 1 to 8, wherein the method further comprises:
extracting the first target data based on a preset model, to obtain the first context information; and
obtaining the first context information from an application layer.

10. The method according to any one of claims 1 to 9, wherein the method further comprises:
sending the first context information, wherein the first context information is used for decoding the encoded first data packet.

11. A communication method, wherein the method is applied to a second apparatus, and the method comprises:
receiving an encoded first data packet; and
performing channel decoding processing on the encoded first data packet based on first context information, to obtain a first data packet, wherein the first context information is associated with first data having a first error tolerance capability, the first context information indicates time association and/or spatial association between two frames, the first error tolerance capability indicates that a frame to which the first data belongs is supported to be obtained based on a preset quantity of data packets, the first data comprises N data packets, the first data packet is any one of the N data packets, and N is a positive integer.

12. The method according to claim 11, wherein the method further comprises:
receiving the first context information from a first apparatus; or
extracting initial first feature data based on a preset model, to obtain context information, and updating the context information based on the current encoded first data packet, to obtain the first context information.

13. The method according to claim 11 or 12, wherein the performing channel decoding processing on the encoded first data packet based on the first context information, to obtain the first data packet comprises:
respectively performing channel decoding processing on M encoded first data packets based on the first context information by using M decoding methods, to obtain M decoded data packets, wherein the M encoded first data packets are obtained by copying the encoded first data packet, the M decoding methods are in one-to-one correspondence with the M encoded first data packets, and M is an integer greater than 1; and
obtaining the first data packet based on the M decoded data packets.

14. The method according to claim 13, wherein the second apparatus comprises a first protocol layer and a second protocol layer;
the respectively performing channel decoding processing on the M encoded first data packets based on the first context information by using the M decoding methods, to obtain the M decoded data packets comprises: respectively performing, at the first protocol layer or the second protocol layer, channel decoding processing on the M encoded first data packets based on the first context information by using the M decoding methods, to obtain the M decoded data packets; and
the obtaining the first data packet based on the M decoded data packets comprises: obtaining, at the first protocol layer, the first data packet based on the M decoded data packets.

15. The method according to claim 13 or 14, wherein the respectively performing channel decoding processing on the M encoded first data packets based on the first context information by using the M decoding methods, to obtain the M decoded data packets comprises:
obtaining channel state information CSI; and
respectively performing channel decoding processing on the M encoded first data packets based on the first context information and the channel state information CSI by using the M decoding methods, to obtain the M decoded data packets.

16. The method according to claim 14, wherein the M decoding methods are in one-to-one correspondence with M channels between the first protocol layer and the second protocol layer.

17. The method according to claim 14 or 16, wherein the first protocol layer comprises one of the following:
a packet data convergence protocol PDCP layer, a radio link control RLC layer, a media access control MAC layer, and a physical PHY layer; and
the second protocol layer comprises one of the following:
a packet data convergence protocol PDCP layer, a radio link control RLC layer, a media access control MAC layer, and a physical PHY layer.

18. The method according to any one of claims 11 to 17, wherein the encoded first data packet carries first indication information, and the first indication information indicates that the encoded first data packet is associated with the first data.

19. The method according to claim 18, wherein the first indication information further indicates the first error tolerance capability.

20. The method according to any one of claims 11 to 19, wherein the method further comprises:
sending first information or second information based on a successfully decoded data packet, wherein the first information indicates that decoding succeeds, and the second information indicates that decoding fails.

21. The method according to claim 20, wherein the sending the first information or the second information based on the successfully decoded data packet comprises:
sending the first information when determining, based on the successfully decoded data packet, that a first condition is met,
wherein the first condition comprises one or more of the following:
a ratio of a quantity of successfully decoded data packets to a quantity of received encoded data packets is not less than a first threshold;
a quantity of unsuccessfully decoded data packets is within a quantity range indicated by the first error tolerance capability; and
an application layer restores the first data based on the successfully decoded data packet.

22. The method according to claim 20, wherein the sending the first information or the second information based on the successfully decoded data packet comprises:
sending the second information when determining, based on the successfully decoded data packet, that a second condition is met,
wherein the second condition comprises one or more of the following:
a ratio of a quantity of successfully decoded data packets to a quantity of received encoded data packets is less than a first threshold;
a quantity of unsuccessfully decoded data packets exceeds a quantity range indicated by the first error tolerance capability; and
an application layer cannot restore the first data based on the successfully decoded data packet.

23. The method according to claim 20 or 22, wherein the second information further indicates to retransmit an encoded data packet that is unsuccessfully decoded.

24. A communication apparatus, comprising a unit or a module configured to perform the method according to any one of claims 1 to 10, or comprising a unit or a module configured to perform the method according to any one of claims 11 to 23.

25. A communication apparatus, comprising a processor and a storage, wherein the storage is configured to store program instructions, and when the processor executes the program instructions, the method according to any one of claims 1 to 10 is performed, or the method according to any one of claims 11 to 23 is performed.

26. A computer-readable storage medium, wherein the computer storage medium stores computer-readable instructions, and when the computer-readable instructions are run on a communication apparatus, the method according to any one of claims 1 to 10 is performed, or the method according to any one of claims 11 to 23 is performed.

27. A computer program product, wherein when the computer program product is run on a device, the device is enabled to perform the method according to any one of claims 1 to 10, or the device is enabled to perform the method according to any one of claims 11 to 23.
